# EUROPEAN PATENT SPECIFICATION

(11) **EP 1 734 150 B1**
(45) Date of publication and mention of the grant of the patent: **09.03.2011**
(21) Application number: 06290978.3
(22) Date of filing: 15.06.2006
(51) Int. Cl.: C23C 14/34, C04B 35/01

(54) **Oxide sintered body, oxide transparent conductive film and manufacturing method thereof**
Oxydischer gesinterter Formkörper, oxydischer, transparenter und stromleitender Film und entsprechendes Herstellungsverfahren
Pièce frittée à base d'oxydes, couche transparente et conductrice à base d'oxydes et procédé pour leur préparation

(30) Priority: 15.06.2005 JP 2005175794
(43) Date of publication of application: 20.12.2006
(73) Proprietor: Sumitomo Metal Mining Co., Ltd., Tokyo (JP)
(72) Inventor: Abe, Yoshiyuki, Sumitomo Metal Mining Co., Ltd., Ichikawa-shi CHiba (JP); Nakayama, Tokuyuki Sumitomo Metal Mining Co Ltd, Ichikawa-shi CHiba (JP); Ohara, Go, Electronics Division, Technical Center, Oume-shi Tokyo (JP); Wake, Riichiro Electronics Div., Technical Center, Oume-shi Tokyo (JP)
(74) Representative: Uchida, Kenji

(56) References cited:
- JP-A- 2004 043 851
- JP-A- 2004 050 643
- US-A1- 2003 148 871
- US-A1- 2004 013 899

## Description

### BACKGROUND OF THE INVENTION

### Field of the Invention:

This invention relates to a transparent-conductive film used in solar batteries, display elements or the like, an oxide sintered body for manufacturing that transparent-conductive film, and manufacturing method thereof.

### Description of the Related Art:

Oxide-transparent-conductive film has high conductivity, and a high transmittance in the visible light range. Therefore, oxide-transparent-conductive film is not only used for electrodes of solar batteries, liquid-crystal display elements, and other kinds of light-receiving elements, but by taking advantage of the reflection absorption characteristics, it can also be used in heat reflecting film that is used in window glass for automobiles or buildings, various kinds of anti-static film, or as an anti-fogging transparent heating body for refrigerated showcases.

Tin oxide (SnO₂) containing antimony or fluorine as a dopant, zinc oxide (ZnO) containing aluminum or gallium as a dopant, and indium oxide (In₂O₃) containing tin as a dopant are widely used for oxide-transparent-conductive film. Particularly, indium oxide film containing tin as a dopant, in other words In₂O₃-Sn type film, referred to as ITO (Indium tin oxide) film is often used because oxide-transparent-conductive film having low resistance can especially be obtained easily.

Vacuum evaporation, ion plating, sputtering, application of a coating for forming a transparent-conductive layer are used as methods for manufacturing these kinds of oxide-transparent-conductive film. Of these methods, vacuum evaporation, ion plating and sputtering are effective methods when using materials having low vapor pressure, or when it is necessary to precisely control the film thickness, and because operation is very simple, they are widely used in industry.

The vacuum evaporation method is a method in which a solid (or fluid) that will serve as the evaporation source is heated in a vacuum of about 10⁻³ to 10⁻² Pa, and after being decomposed into gas molecules or atoms, it is then once again condensed on the surface of a substrate as a thin film. A resistance heating method (RH method) or electron-beam heating method (EB method, electron-beam evaporation method) are typically used as a method for heating the evaporation source, however, laser-beam heating or high-frequency induction heating can also be used. Also, the methods of flash evaporation, arc-plasma evaporation and reactive evaporation are also known and are included in the vacuum evaporation method (refer to non-patent document 1).

In the case of depositing an oxide film such as ITO, the electron-beam evaporation method has often been used in the past. An ITO sintered body (called an ITO tablet or ITO pellet) is used as the evaporation source, O₂ gas, which is used as a reactant gas, is introduced into a film formation chamber (chamber), and thermal electrons that jump from the thermal-electron-generation filament (mainly a W wire) are accelerated in an electric field and irradiated onto the ITO tablet; the irradiated area then becomes locally heated and evaporates and is deposited onto the substrate. Also, by activating the vaporized material or reactant gas (O₂ gas, etc.) using a thermal-electron emitter or RF discharge, it is possible to manufacture a low-resistance film on even a low-temperature substrate. This method is called the activation-reaction-evaporation method (ARE method), and is a useful method for forming ITO film.

Also, the high-density plasma assist evaporation method (HDPE method) that uses a plasma gun is widely used for forming ITO film (for example, refer to non-patent document 2). In this method, arc discharge that uses a plasma generation apparatus (plasma gun) is used. An arc discharge is maintained between the cathode inside that plasma gun and a crucible (anode) of the evaporation source. The electrodes that are discharged from the cathode are guided by a magnetic field, concentrated and irradiated onto a local area of the ITO tablet which is arranged in the crucible. The evaporation material is evaporated from the area that is locally heated by this electron beam and deposited onto the substrate. The vaporized vaporization material and the introduced O₂ gas are activated inside the plasma, so it is possible to manufacture ITO film having good electrical characteristics.

Of the vacuum evaporation methods, methods of ionizing the evaporation material and reactant gas are collectively referred to as the ion-plating method (IP method), and since ITO film having low resistance and a high transmittance is obtained, this method is widely used in industry (for example, refer to non-patent document 3).

On the other hand, when considering solar batteries in which oxide-transparent-conductive film is used, solar batteries comprise layered p-type and n-type semiconductors, and are classified according to the type of semiconductor. The most commonly used solar batteries use silicon, which is stable and an abundant resource. The silicon used for solar batteries can be divided into three types: monocrystalline silicon, multicrystalline silicon, and amorphous silicon. Also, solar batteries, called compound-thin-film solar batteries, are being developed that use compound semiconductors such as CuInSe₂, GaAs, CdTe, etc.

However, in each type of solar battery, oxide-transparent-conductive film is essential for the electrodes that are used on the front side which light shines, and conventionally, ITO film, or zinc oxide (ZnO) film doped with aluminum or gallium have been used. Characteristics such as low resistance, and high transmittance of solar light is desired for these oxide-transparent-conductive films.

Moreover, as the inventors have disclosed in patent document 1 (Japanese Patent Application Publication No. 2004-43851), it has recently become evident that crystalline oxide-transparent-conductive film comprising mainly Indium and including tungsten (crystalline In-W-O) is useful for use in the transparent electrodes of a solar battery. Not only do these oxide-transparent-conductive films have low resistance and excellent light transmission characteristics in the visible light range, but compared with the aforementioned ITO film or zinc oxide type film that have been conventionally used, they have excellent light transmission characteristics in the near infrared range. Therefore, by using these kinds of oxide-transparent-conductive film in the electrodes on the front side of solar batteries, it is possible to effectively utilize near infrared energy as well.

Next, EL (electroluminescence) elements will be explained.

EL elements use electroluminescence, and because they are self luminous, visibility is high, and they differ from display elements for a liquid-crystal or plasma display in that they are completely solid elements. Therefore, EL elements have an advantage in that they have excellent resistance to shock, and they are receiving much attention for use as light-emitting elements for various kinds of display devices.

Among EL elements, there are inorganic EL elements that use inorganic compounds as light-emitting material, and there are organic EL elements that use organic compounds.

Of these, with organic EL elements it is possible to obtain bright light emission even when the drive voltage is greatly lowered (for example DC voltage of 10 V or less), so miniaturization is easy, and research is actively being carried out for application as a next-generation display element.

As a structure of an organic EL element, a bottom emission type structure is normally employed, which has basically a layered structure with a transparent insulating substrate, anode (transparent electrode), electron hole transport layer, light-emitting layer, electron transport layer, and cathode (metallic electrode), where a transparent-conductive thin film is formed on a transparent insulating substrate such as a glass plate, and the transparent-conductive thin film serves as an anode. In this case, emitted light is obtained from the substrate side.

The electrodes for this kind of organic EL element or LCD (liquid-crystal display) require that the surface be a smooth transparent-conductive thin film. Particularly, in the case of an electrode for an organic EL element, an ultra-thin film made of an organic compound is formed on top of the electrode, it is desired that the transparent-conductive thin film have excellent surface smoothness. The surface smoothness is largely affected by the crystallinity of the film. Even for film having the same composition, transparent-conductive thin film having a non-crystalline structure (non-crystalline film) in which there is no grain boundary has better surface smoothness than a transparent-conductive thin film having a crystalline structure (crystalline film).

Even in the case of ITO film having conventional composition, a non-crystalline film has better surface smoothness. Non-crystalline ITO can be obtained by lowering the substrate temperature during film formation, then forming film at low temperature (less than the ITO crystallization temperature of 150 °C) by electron-beam evaporation, ion plating, high-density plasma assist evaporation or sputtering. However, the resistivity of non-crystalline ITO film is limited at 9 x 10⁻⁴ Ωcm, and in order to form a film having low surface resistance, it is necessary to form the film itself so that it is thick. However, as the film thickness of ITO film becomes thick, a problem of coloring the film occurs.

Also, even for ITO film that is formed at room temperature without heating the substrate, in a film formation method that involves plasma such as electron-beam evaporation, ion plating, high-density plasma assist evaporation, or sputtering, the temperature of the substrate surface rises locally due to effects of the heat received from the plasma, making it easy to obtain film having a minute crystalline phase and non-crystalline phase. The existence of a minute crystalline phase can be checked by X-ray diffraction, a transmission electron microscope, or electron-beam diffraction. However, when this kind of minute crystalline phase is formed on part of the film, it has a large effect on the surface smoothness. Also, when forming the transparent conductive thin film into a specified shape by etching using a weak acid, there is a problem in that there may be cases in which only the crystalline phase is not removed and remains.

For a non-crystalline ITO film, in addition to the aforementioned problem of resistivity, there is also a problem with stability. When non-crystalline ITO film is used as an electrode for an LCD or organic EL element, the transparent-conductive thin film may become crystallized during the manufacturing process, when performing heating at 150 °C in the heating history after the electrode has been formed. The reason for this is that the non-crystalline phase is a metastable phase. When the non-crystalline phase becomes crystallized, crystal particles are formed so there is a problem in that surface smoothness becomes poor, and at the same time, resistivity greatly changes.

The aforementioned surface smoothness and small specific resistivity are desired for a transparent-conductive-thin film for a display device such as an organic EL element or LCD, however, as the inventors disclosed in patent document 2 (Japanese Patent Application Publication No. 2004-52102), a non-crystalline oxide-transparent-conductive film containing indium as the main component and also including a specified amount of tungsten (non-crystalline In-W-O film) is suitable for transparent-conductive thin film for display devices such as an organic EL element or LCD. In-W-O has higher crystallization temperature than ITO, so even when film is formed using a method that uses plasma, it is possible to obtain a stable non-crystalline film. Furthermore, non-crystalline In-W-O film not only has excellent surface smoothness, but also has low resistance, so it is especially suitable for use in cases where surface smoothness and a low specific resistivity are required, such as in the case of a display device like an organic EL or LCD.

Particularly, in the case of transparent-conductive-thin film used for an organic EL element, an organic compound ultra-thin film is formed on top of that film, so surface smoothness is required for the transparent-conductive-thin film, and therefore non-crystalline In-W-O film is suitable as a transparent-conductive-thin film used for an organic EL element. When the surface of transparent-conductive-thin film is not smooth, leak damage to the organic compound ultra-thin film will occur.

Also, as the inventors disclosed in patent document 3 (Japanese Patent Application Publication No. 2004-50643) layered thin film made from a non-crystalline indium oxide film containing tungsten (non-crystalline In-W-O film) and a metallic-conductive-film layer has excellent surface smoothness, low sheet resistance of 1 to 5Ω per square even at a film thickness of 100 to 150 nm, excellent transparency, and is useful as a transparent electrode for a high-definition or large LCD or organic EL element. With this thin-film structure, indium-oxide film containing tungsten is a non-crystalline film, and can be formed by vacuum evaporation or ion plating; and by forming it on the surface of a metallic conductive film layer, it protects the metallic conductive film layer.

The non-crystalline In-W-O film described above can be manufactured using a tablet made from an oxide-sintered body containing the elements of that film (in other words a tablet made from an In-W-O oxide-sintered body) as raw material, and formed by a kind of vacuum evaporation such as electron-beam evaporation, ion plating, or high-density plasma assist evaporation. Taking the improvement of productivity and reduction of manufacturing cost into consideration, it is necessary to form the film at high speed, and, by forming the film using particularly electron-beam evaporation, ion plating, or high-density plasma assist evaporation, it is possible to manufacture non-crystalline In-W-O film having excellent conductivity and transparency at high speed. In these film formation methods, by increasing the electron beam that is irradiated onto the oxide-sintered-body tablet that is the raw material, it is possible to form the film at high speed.

However, when a high electron beam is used in order to form non-crystalline In-W-O film at high speed, the oxide-sintered-body tablet will break, and it is not possible to perform stable film formation. When the oxide-sintered-body tablet breaks during film formation, the speed of film formation will suddenly decrease. Therefore, it is necessary to stop film formation, and to replace the tablet with an unused oxide-sintered-body tablet, which causes productivity to become poor.
[Patent Document 1]
   Japanese Patent Application Publication No. 2004-42851
[Patent Document 2]
   Japanese Patent Application Publication No. 2004-52102
[Patent Document 3]
   Japanese Patent Application Publication No. 2004-50643
[Non-patent Document 1]
   'Handbook of Manufacturing and Evaluating Thin Film, and Related Application Technology', Fujitec Corporation, November 5, 1984, pg. 250 - 255.
[Non-patent Document 2]
   'Vacuum', Vol. 44, No. 4, 2001, pg. 435 - 439.
[Non-patent Document 3]
   'Transparent Conductive Film Technology', Ohmsha Ltd., 1999, pg. 205 - 211.

### SUMMARY OF THE INVENTION

Taking the aforementioned problems into consideration, the object of the present invention is to provide an oxide-sintered body in which breakage and cracking do not occur when using the oxide-sintered body to manufacture oxide-transparent-conductive film using a vacuum evaporation method such as electron-beam evaporation, ion-plating and high-density plasma assist evaporation, even when irradiated with a high intensity electron beam.

The oxide-sintered body of a first embodiment of the present invention contains indium oxide in which tungsten is contained in solid solution so that the atomic ratio of tungsten with respect to indium is 0.001 to 0.034, and the density is 4.0 g/cm³ to 6.5 g/cm³.

The oxide-sintered body of a second embodiment of the present invention contains indium oxide in which tungsten and zinc are contained in solid solution so that the atomic ratio of tungsten with respect to indium is 0.001 to 0.034, the atomic ratio of zinc with respect to indium is 0.00018 to 0.017, and the density is 4.0 g/cm³ to 6.5 g/cm³.

It is preferred that the aforementioned oxide-sintered body includes no metallic phase.

It is preferred that the aforementioned oxide-sintered body have an average crystal grain size of 10 µm or less, and that the specific resistivity of the oxide-sintered body be 1 kΩcm or less.

A first embodiment of a manufacturing method for the oxide-sintered body of the present invention comprises: a first process of preparing and mixing indium-oxide powder and tungsten-oxide powder so that the atomic ratio of tungsten with respect to indium is 0.001 to 0.034; and a second process of performing hot-press sintering of the compound obtained in process 1 at a temperature of 700 °C to 900 °C, for a period equal to or greater than 1 hour and less than 3 hours, and at a pressure of 2.45 MPa to 29.40 MPa to obtain an oxide-sintered body.

A second embodiment of a manufacturing method for the oxide-sintered body of the present invention comprises: a first process of preparing and mixing indium-oxide powder, tungsten-oxide powder and zinc-oxide powder so that the atomic ratio of tungsten with respect to indium is 0.001 to 0.034; and the atomic ratio of zinc with respect to indium is 0.00018 to 0.017; and a second process of performing hot-press sintering of the compound obtained in process 1 at a temperature of 700 °C to 900 °C, for a period equal to or greater than 1 hour and less than 3 hours, and at a pressure of 2.45 MPa to 29.40 MPa to obtain an oxide-sintered body.

A third embodiment of a manufacturing method for the oxide-sintered body of the present invention comprises: a first process of preparing and mixing indium-oxide powder and tungsten-oxide powder so that the atomic ratio of tungsten with respect to indium is 0.001 to 0.034; a second process of performing cold isostatic pressing of the compound obtained in process 1 at a pressure of 9.8 MPa to 294 MPa to form a compact; and a third process of performing sintering of the compact obtained in process 2 at atmospheric pressure, at a temperature of 1300 °C or more, for a period of 5 hours or more to obtain an oxide-sintered body.

A fourth embodiment of a manufacturing method for the oxide-sintered body of the present invention comprises: a first step of preparing and mixing indium-oxide powder, tungsten-oxide powder and zinc powder so that the atomic ratio of tungsten with respect to indium is 0.001 to 0.034 and the atomic ratio of zinc with respect to indium is 0.00018 to 0.017; a second process of performing cold isostatic pressing of the compound obtained in process 1 at a pressure of 9.8 MPa to 294 MPa to form a compact; and a third process of performing sintering of the compact obtained in process 2 at atmospheric pressure, at a temperature of 1000 °C to 1300 °C, for a period of 1 hour to 5 hours to obtain an oxide-sintered body.

It is preferred that the aforementioned sintering processes be performed in an atmosphere in which oxygen is introduced into the sintering furnace at a ratio of 3 to 8 L/min per 0.1 m³ of the furnace volume. Also, it is preferred that when cooling the furnace after the sintering process, the introduction of oxygen be stopped.

The oxide-transparent-conductive film of the present invention is an oxide-transparent-conductive film that is manufactured by a vacuum evaporation method using a tablet of any one of the aforementioned oxide-sintered bodies, and has a specific resistivity of 9 x 10⁻⁴ Ωcm or less, and average transmittance of the film itself of 82% or greater in light having a wavelength of 400 to 800 nm.

It is preferred that the aforementioned oxide-transparent-conductive film have an average transmittance of the film itself of 80% or greater in light having a wavelength of 900 to 1100 nm.

A method for manufacturing the oxide-transparent-conductive film of the present invention is characterized in that the aforementioned oxide-sintered body tablet is used, and after a film is manufactured by vacuum evaporation on a glass substrate at a temperature less than 130 °C or less, the manufactured film is heat treated in inert gas or in a vacuum at 200 to 400 °C.

The oxide-sintered body of the present invention and the oxide-transparent-conductive film that is manufactured using it is made from mainly indium oxide and tungsten oxide, or from indium oxide, tungsten oxide and zinc oxide, however, within a range that will not hinder the characteristics of the present invention, it is possible to include one or more other elements selected from among Sn, Ga, Cd, Ti, Ir, Ru, Re, Mo, and Os, and oxide-sintered body and oxide-transparent-conductive film that includes these elements also fall within the scope of the present invention.

### [Effect of the Invention]

By using tablets made from the oxide-sintered body of the present invention as an evaporation source in a vacuum evaporation method such as electron-beam evaporation, ion-plating, and high-density plasma assist evaporation, it is possible to form film stably without the occurrence of breakage or cracking in the oxide-sintered body and without having to stop film formation, even when performing irradiation with a high intensity electron beam.

By using tablets of the oxide-sintered body of the present invention in various methods of vacuum evaporation, it is possible to manufacture stably and at high speed oxide-transparent-conductive film having low resistance and a large transmittance from the visible light range to near infrared range that can be suitably used in solar batteries, and oxide-transparent-conductive film having low resistance and excellent surface smoothness that can be suitably used in display devices, and thus it is possible to improve productivity. Therefore, by using the oxide-sintered body of this invention, it is possible to manufacture highly efficient solar batteries, and organic ELs and LCDs having excellent performance at low cost.

### DESCRIPTION OF THE PREFERRED EMBODIMENTS

With the objective of obtaining a tablet as an evaporation source to be used in all kinds of vacuum evaporation such as electron-beam evaporation, ion plating, or high-density-plasma-assist evaporation that would make it possible to perform film formation stably without the tablet breaking or cracking when irradiated by a large electron beam, and without having to stop the film formation process, the inventors have diligently pursued research and development by manufacturing under various manufacturing conditions oxide-sintered-body tablets having indium oxide as the main component mixed with solid solution tungsten (hereafter referred to as an In-W-O type oxide-sintered-body tablet), and oxide-sintered-body tablets having indium oxide as the main component mixed with solid solution tungsten and zinc (hereafter referred to as an In-W-Zn-O type oxide-sintered-body tablet), and manufacturing tablets for evaporation having various densities.

The tablets were irradiated by an electron beam for a fixed amount of time after which the tablets were checked for breakage or cracking. It was found that by mixing a specified amount of tungsten in an In-W-O type oxide-sintered-body tablet and bringing the density within a specified range, the tablet did not break even when irradiated with a high electron beam, and it was possible to form film at high speed using a vacuum evaporation method such as electron-beam evaporation, ion plating, or high-density-plasma-assist evaporation.

Also, it was found that by mixing a specified amount of tungsten and zinc in an In-W-O type oxide-sintered-body tablet and bringing the density within a specified range, the tablet did not break even when irradiated with a high electron beam, and it was possible to form film at high speed using a vacuum evaporation method such as electron-beam evaporation, ion plating, or high-density-plasma-assist evaporation.

Furthermore, it was found that by mixing in a specified amount of zinc in an indium and tungsten oxide, the sinterability was greatly improved.

Also, it was found that when the average crystal grain size is a specified size or less, and the specific resistivity is a specified value or less, it is possible to stably irradiate the tablet with a high electron beam for a long period of time, and to maintain high-speed film formation.

The present invention was accomplished based on the above finding and knowledge. The oxide-sintered body and oxide-transparent-conductive film of the present invention will be explained in detail below.

### 1. Oxide-sintered body

The In-W-O type oxide sintered body of this invention contains tungsten at an atomic ratio W/In of 0.001 to 0.034, and the density is 4.0 g/cm³ to 6.5 g/cm³.

The In-W-Zn-O type oxide sintered body of this invention contains tungsten at an atomic ratio W/In of 0.001 to 0.034, and zinc at an atomic ratio Zn/In of 0.00018 to 0.017, and the density is 4.0 g/cm³ to 6.5 g/cm³.

Tungsten has the function of increasing the density of carrier electrons in the obtained oxide-conductive film and improving conductivity. When the W/In atomic ratio is less than 0.001, the aforementioned effect is not obtained, and when the atomic ratio is greater than 0.034, a remarkable drop in mobility occurs due to impurity scattering, and the resistance of the obtained oxide-conductive film rises.

When the density of the oxide-sintered body is less than 4.0 g/cm³, the strength of the sintered body itself becomes poor, so it becomes easy for cracking or breakage to occur due to a small amount of localized thermal expansion. When the density is greater than 6.5 g/cm³, it is not possible to absorb stress or strain that is generated locally during electron-beam irradiation, and thus it becomes easy for cracks to occur. In a vacuum evaporation method such as electron-beam evaporation, ion plating or high-density-plasma-assist evaporation, film is formed by irradiating an electron beam onto part of the surface of the oxide-sintered-body tablet and locally heating the tablet to generate an evaporant. When the tablet is locally heated, thermal expansion occurs in that part, creating stress or strain in the sintered body.

Zinc has the effect of greatly improving sinterability. When the atomic ratio Zn/In is less than 0.00018, the additional effect for improving sinterability of the sintered body is not obtained. On the other hand, when the atomic ratio Zn/In is greater than 0.017, the sinterability of the sintered body is not further improved even when Zn is added.

For an In-W-O type oxide-sintered body that does not contain zinc, when manufacturing a tablet having a density of 4.0 g/cm³ or more by atmospheric pressure sintering, manufacturing is only possible under high-temperature, long-time sintering conditions of 1300 °C or more for 5 hours of more. Also, it is only possible to obtain a sintered body having a low density of 4.0 to 4.2 g/cm³. For an In-W-O type oxide-sintered body that contains no zinc, in order to obtain a sintered body having a density greater than 4.2 g/cm³ and equal to or less than 6.5 g/cm³, it is necessary to use a hot press sintering method.

On the other hand, by mixing in zinc oxide at an atomic ratio Zn/In of 0.00018 to 0.017, it becomes possible to easily manufacture an oxide-sintered-body tablet having a density of 4.0 g/cm³ to 6.5 g/cm³ by atmospheric pressure sintering at a temperature of 1000 to 1200 °C.

Even for an oxide-sintered by having a density of 4.0 g/cm³ to 6.5 g/cm³, when even a small amount of a metallic phase contained in the sintered body, it is not possible to obtain sufficient durability for when the tablet is irradiated by an electron beam. Generally, the coefficient of thermal expansion of metal is higher than that of an oxide, so when heated locally by electron-beam irradiation, thermal expansion in the metallic phase portion becomes great, and causes cracking to occur.

For the In-W-O type oxide-sintered body and In-W-Zn-O type oxide sintered body of this invention, it is preferred that the average crystal grain size be equal to or less than 10µm, and that the specific resistivity be equal to or less than 1 kΩcm. Within this range of average crystal grain size and specific resistivity, it is possible to irradiate a stronger electron beam for a longer period of time and more stably, and thus is effective for high-speed film formation.

When the average crystal grain size exceeds 10µm, it becomes easy for stress to become concentrated in a crystal having a large grain size due to localized heating by an electron beam, and thus cracking and breakage occur easily. Also, when the specific resistivity of the sintered body exceeds 1 kΩcm, electric charge builds up when performing electron-beam irradiation, and the body becomes charged, so it becomes difficult to stably irradiate a strong electron beam for a long period of time.

Also, as long as it is within a range that will not hinder the characteristics of the present invention, it is possible to include other elements in the oxide-sintered body of the invention (for example, Sn, Ga, Cd, Ti, Ir, Ru, Re, Mo, Os, etc.). However, depending on the elements added (for example in the case of Bi or Pb), the transmittance of the film may decrease or the specific resistivity may become poor, and when these kinds of elements are added, the characteristics of the oxide-sintered body of this invention will be hindered.

Next, the method for manufacturing the In-W-O type oxide-sintered body and In-W-Zn-O type oxide-sintered body of this invention will be explained.

To manufacture an In-W-O type oxide-sintered body, In₂O₃ powder having an average grain size equal to or less than 1 µm and WO₃ powder having an average grain size equal to or less than 1 µm are used as raw material powder, and the In₂O₃ powder and WO₃ powder are prepared so that the W/In atomic ratio is a specified ratio. These raw materials are uniformly mixed in a dry ball mill, V blender or the like, and then put into a carbon container and sintered using a hot press method. The sintering temperature can be 700 to 900 °C, the pressure can be 2.45 MPa to 29.40 MPa (25 kgf/cm² to 300 kgf/cm²), and the sintering time can be 1 to 10 hours. It is preferred that the atmosphere during the hot press be an inert gas such as Ar gas, or a vacuum. It is also possible to manufacture the In-W-O type oxide-sintered body by atmospheric pressure sintering, however, as explained above, it is necessary to perform manufacturing under sintering conditions of high temperature and a long period of time.

To manufacture an In-W-Zn-O type oxide-sintered body, In₂O₃ powder having an average grain size equal to or less than 1 µm, WO₃ powder having an average grain size equal to or less than 1 µm and ZnO powder having an average grain size equal to or less than 1 µm are used as raw material powder, and the In₂O₃ powder, WO₃ powder and ZnO powder are prepared so that the W/In atomic ratio and Zn/In atomic ratio are specified ratios. These raw materials are placed in a resin pot, and mixed in a wet ball mill or the like. When doing this, a hard ZrO₂ ball can be used as the mixing ball. After mixing, the slurry is removed and filtration, drying and granulation are performed. Next, the granulated matter is pressurized to 9.8 MPa (0.1 ton/cm²) to 294 MPa (3 ton/cm²) using a cold isostatic press.

Next, the obtained compact is sintered in a sintering furnace in an oxygen atmosphere at 1000 °C to 1300 °C for 1 to 5 hours (atmospheric pressure sintering). At this time, in order that the uniform heat within the furnace is not lost, it is preferred that the temperature be raised at about 1 °C/minute, and that when performing cooling after sintering, the supply of oxygen is stopped and the temperature is cooled to 1000 °C at about 10 °C/minute. Also, it is preferred that the amount of oxygen that is introduced into the sintering furnace flow at a rate of 3 to 8 L/min per each 0.1 m³ of the furnace volume. When the amount of introduced oxygen drops, the volatility of the WO₃ and ZnO becomes severe, and it becomes difficult to obtain a sintered body having the specified composition. When the amount of introduced oxygen increases, the uniformity of heat within the furnace becomes poor. When manufacturing an In-W-Zn-O type oxide-sintered body, it is also possible to perform sintering using a hot press method similar to as when manufacturing an In-W-O type oxide-sintered body.

### 2. Oxide transparent conductive film

As described above, In-W-O type oxide-transparent-conductive film is useful as a transparent electrode in a solar battery or display device. The reason for that is explained below.

When manufacturing an oxide-transparent-conductive film from an In-W-O type oxide-sintered body, the position of indium having an atomic valence of 3 is occupied by tungsten having an atomic valence of 4 to 6 as impurity ions, and by doing this, carrier electrons are discharged, which increases the conductivity. Generally, when impurity ions are increased in an n-type semiconductor like indium oxide, the number of carrier electrons increases, however, the mobility of the carrier electrons decreases due to impurity-ion scattering. However, when tungsten is added to indium oxide as impurity ions, it is possible to increase the number of carrier electrons without greatly decreasing mobility. Therefore, when tungsten is included, it is possible to increase the number of carrier electrons in a high state of carrier electron mobility, so it is possible to obtain an oxide-transparent-conductive film having low resistance and high infrared transmission rate. In this invention, this is the main reason for including tungsten.

The manufacturing conditions for manufacturing oxide-transparent-conductive film are not particularly limited, however, more specifically, by using the oxide-sintered body of this invention, it is possible to manufacture a mainly non-crystalline oxide-transparent-conductive film on a substrate at a temperature of 130 °C or less by a vacuum evaporation method such a electron-beam evaporation, ion plating or high-density-plasma-assist evaporation.

The obtained film has an average roughness (Ra) in the centerline of the surface of 1.5 nm or less, the surface smoothness is good, and has high conductance with a specific resistivity of 9 x 10⁻⁴ Ωcm or less, and since the average transmittance of the film itself at a wavelength of 400 to 800 nm is 82% or more, and the internal stress is low, the film is useful as a transparent electrode for an organic EL and the like.

Also, after the oxide-transparent-conductive film is manufactured using the method described above, it is preferred that the obtained film be heated in an inert gas or vacuum at 200 to 400 °C. When heating is performed in the aforementioned range of heating temperature, a crystalline oxide-transparent-conductive film is obtained. This crystalline oxide-transparent-conductive film has as specific resistivity of 9 x 10⁻⁴ Ωcm or less, an average transmittance of the film itself of 82% or more for light having a wavelength of 400 to 800 nm, and furthermore an average transmittance of the film itself of 80% or more for light having a wavelength of 900 to 1100 nm, and the oxide-transparent-conductive film has low resistance and a large transmittance from the visible light range to the near infrared light range.

By manufacturing an oxide-transparent-conductive film according to a procedure as described above using the oxide-sintered body of this invention and a vacuum evaporation method such as electron-beam evaporation, ion plating and high-density-plasma-assist evaporation, it is possible to obtain an the oxide-transparent-conductive film that has low resistance and a large transmittance from the visible light range to the near infrared light range.

Therefore, by manufacturing transparent-conductive film using the oxide-sintered body of this invention with various vacuum evaporation methods such as electron-beam evaporation, ion plating or high-density-plasma-assist evaporation, it is possible to manufacture stably and at high speed oxide-transparent-conductive film having low resistance and high transmittance, or an oxide-transparent-conductive film having good surface smoothness, low resistance, and low internal stress.

### [Examples]

The present invention will be explained in more detail below using examples.

### (Examples 1 to 5, and Reference Example 6) Manufacturing a In-W-O type oxide-sintered-body tablet using a hot press method (4.1 to 6.4 g/cm³)

In₂O₃ powder having an average grain size of 1 µm or less, and WO₃ powder having an average grain size of 1 µm or less were used as raw materials, and the In₂O₃ powder and WO₃ powder were prepared so that the W/In atomic ratio was 0.006. These raw materials were uniformly mixed in a dry ball mill, V blender, or the like, and then placed in a carbon vessel and sintered under various conditions using a hot press method. The sintering temperature was selected from the range of 700 to 900 °C, and the pressure was selected from the range 2.45 MPa (25 kgf/cm²) to 29.40 MPa (300 kgf/cm²), and the sintering time was fixed at 1 hour. Sintering was performed in an atmosphere of an inert gas (Ar gas).

The obtained oxide-sintered body was formed into a cylindrical shape having a 30 mm diameter and 40 mm thickness, and the volume and mass were measured and the density was calculated. By changing the sintering temperature and sintering pressure, oxide-sintered-body tablets having various densities were manufactured. The density of the obtained oxide-sintered-body tablets was 4.1 to 6.4 g/cm³. The measurement results are shown in Table 1.

The obtained oxide-sintered body was ground into powder in a mortar, and by performing powder X-ray diffraction measurement using a CuKα ray was found to be structured with a single bixbite indium oxide crystal phase (phase listed as 6-416 in the JCPDS card). Also, in order to investigate the composition distribution of the oxide-sintered body, surface analysis by EPMA was performed for the surface of a fractured section, and it was found that tungsten and indium were uniformly distributed inside each crystal grain. Therefore, it was considered that tungsten was contained in solid solution in the indium-oxide crystal phase.

After observation of the surface of the fractured section of the oxide-sintered body with a scanning electron microscope (S-800, Hitachi, Ltd.), the average value of the crystal grain size of 100 crystals from the oxide-sintered body was found, and in each case was 4 to 9 µm. Also, the surface resistance of the circular surface which is an electron-beam irradiation surface on the oxide-sintered body was measured using a 4-pin probe resistivity meter Loresta EP (MCP-T360, Dia Instruments Co., Ltd.) and the specific resistivity was calculated and found to be 0.9 kΩcm or less. Also, composition analysis using ICP emission spectrometry was performed for all of the oxide-sintered bodies, and it was found that they had a formulated composition (composition based on the mixture ratio of raw material powders).

A magnetic-field-deflection type electron-beam evaporation apparatus was used in manufacturing transparent-conductive film. The vacuum evacuation system of that evaporation apparatus was constructed from a low vacuum evacuation system using a rotary pump and a high-vacuum evacuation system using a cryopump, and it was possible to perform evacuation up to 5 x 10⁻⁵ Pa. The electron beam was generated by heating a filament, and accelerated by an electric field applied between a cathode and anode, and after being bent in a magnetic field by a permanent magnet, was irradiated on a tablet that was placed inside a tungsten crucible. The intensity of the electron beam could be adjusted by changing the voltage applied to the filament. Also, it was possible to change the irradiation position of the beam by changing the acceleration voltage between the cathode and anode.

By performing film formation according to the procedure described below for the obtained oxide-sintered tablet, endurance testing was executed. Ar gas and O₂ gas were introduced into a vacuum chamber, and the pressure was maintained at 1.5 x 10⁻² Pa. The cylindrical shaped tablets of examples 1 to 5, and Reference Example 6 were stood up and placed in a tungsten crucible, and an electron beam was irradiated continuously on the center section of the circular surface of the tablet for 60 minutes. The voltage of the electron gun was set at 9 kV, and the current was 150 mA. The substrate on which thin film was formed was a glass substrate (1.1 mm thick Coming 7059), and the substrate temperature was from room temperature to 130 °C. After irradiation by the electron beam for 60 minutes, the tablet inside the crucible was observed and visually checked for cracking or breakage.

Endurance testing was performed under the above conditions for 20 tablets each of the tablets for examples 1 to 5, and Reference Example 6, and no breakage or cracking occurred in any of the tablets. Using this kind of tablet is useful in that it can be used in performing film formation stably and at high speed.

Using the obtained oxide-sintered-body tablet, film formation was performed using the aforementioned magnetic-field-deflection type electron beam evaporation apparatus. The film was formed on a glass substrate (1.1 mm thick Coming 7059) for just the amount of time calculated from the respective film-formation speed so that the thickness of each film becomes 200 nm, and thin film was manufactured. The temperature of the glass substrate was from room temperature to 130 °C.

The surface resistance of the obtained thin film was measured using a 4-pin probe resistivity meter Loresta EP (MCP-T360, Dia Instruments Co., Ltd.) and the specific resistivity was calculated. Also, the transmittance of the film including the glass substrate (glass substrate with film) (T _{film + substrate} (%)) and the transmittance of just the glass substrate (T substrate (%)) were measured using a spectrophotometer (U-4000, Hitachi Co., Ltd). Also, the transmittance of the film itself was calculated (T _{film + substrate} / T _{substrate}) x 100 (%).

Also, the centerline average surface roughness (Ra) in a 10 µm x 10 µm area of the film was measured using an atomic force microscope (NS-III, DS5000 system, Digital Instruments). The crystallinity of the film was measured by X-ray diffraction using a CuKα ray. The composition of the film was measured using ICP emission spectrometry.

As a result, in all of the obtained thin films, the specific resistivity was 7 x 10⁻⁴ Ωcm or less, the average transmittance of the film itself in the visible range (400 to 600 nm) was 83 to 90%, the average transmittance of the film itself in the near infrared range of 900 to 1100 nm was 60 to 74%, the centerline average surface roughness (Ra) on the film surface was 1.5 nm or less, and the film was non crystalline. Film having these characteristics is useful as a transparent electrode of display element such as an organic EL or LCD. The composition of the film was nearly the same as the composition of the oxide-sintered-body tablet.

Also, this film was annealed for 1 hour at 250 °C in a nitrogen atmosphere, and similarly the characteristics were evaluated. The annealed film was found through X-ray diffraction measurement to be an indium-oxide crystal film having bixbite type structure. As a result, compared with the film before annealing, the film had good light transmission in the near infrared range as well as the visible light range, where the average transmittance of the film itself in the visible range (400 to 800 nm) became 87 to 93%, and in the near infrared range of 900 to 1100 nm became 85 to 89%. Also, the specific resistivity of the film was 3 x 10⁻⁴ to 6 x 10⁻⁴ Ωcm. By using this kind of oxide-transparent-conductive film for a transparent electrode of a solar battery, it is possible to effectively use near infrared energy as well, so it is useful.

### (Comparative Example 1) Manufacturing In-W-O type oxide-sintered-body tablets (3.8 g/cm³) using hot press sintering

Except for a sintering temperature of 700 °C, sintering time of 0.5 hours and a sintering pressure of 4.91 MPa, oxide-sintered-body tablets were manufactured under the same conditions as examples 1 to 5, and Reference Example 6 using a hot press sintering method, and the density was 3.8 g/cm³. The measurement results are shown in Table 1.

The obtained oxide-sintered body was ground into powder in a mortar, and by performing powder X-ray diffraction measurement using a CuKα ray was found to be structured with a single bixbite indium oxide crystal phase (phase listed as 6-416 in the JCPDS card). Also, in order to investigate the composition distribution of the oxide-sintered body, surface analysis by EPMA was performed for the surface of a fractured section, and it was found that tungsten and indium were uniformly distributed inside each crystal grain. Therefore, it was considered that tungsten was contained in solid solution in the indium-oxide crystal phase.

After observation of the surface of the fractured section of the oxide-sintered body with a scanning electron microscope (S-800, Hitachi, Ltd.), the average value of the crystal grain size of 100 crystals from the oxide-sintered body was found, and in each case was 4 to 9 µm. Also, the surface resistance of the circular electron-beam irradiation surface on the oxide-sintered body was measured using a 4-pin probe resistivity meter Loresta EP (MCP-T360, Dia Instruments Co., Ltd.) and the specific resistivity was calculated and found to be 0.9 kΩcm or less. Also, composition analysis using ICP emission spectrometry was performed for all of the oxide-sintered bodies, and it was found that they had a formulated composition (composition based on the mixture ratio of raw material powders).

Endurance testing was performed similar to as was done for examples 1 to 5 and Reference Example 6 for 20 tablets, and it was found that all of the tablets broke. This kind of tablet cannot be used to form film stably at high speed. The measurement results are shown in Table 1.

### (Comparative Example 2) Manufacturing In-W-O type oxide-sintered-body tablets (6.7 g/cm³) using hot press sintering

Except for a sintering temperature of 900 °C, sintering time of 3 hours and a sintering pressure of 29.40 MPa, oxide-sintered-body tablets were manufactured under the same conditions as examples 1 to 5 and Reference Example 6 using a hot press sintering method, and the density was 6.7 g/cm³. The measurement results are shown in Table 1.

The obtained oxide-sintered body was ground into powder in a mortar, and by performing powder X-ray diffraction measurement using a CuKα wray was found to be structured with a single bixbite indium oxide crystal phase (phase listed as 6-416 in the JCPDS card). Also, in order to investigate the composition distribution of the oxide-sintered body, surface analysis by EPMA was performed for the surface of a fractured section, and it was found that tungsten and indium were uniformly distributed inside each crystal grain. Therefore, it was considered that tungsten was contained in solid solution in the indium-oxide crystal phase.

After observation of the surface of the fractured section of the oxide-sintered body with a scanning electron microscope (S-800, Hitachi, Ltd.), the average value of the crystal grain size of 100 crystals from the oxide-sintered body was found, and in each case was 4 to 9 µm. Also, the surface resistance of the circular electron-beam irradiation surface on the oxide-sintered body was measured using a 4-pin probe resistivity meter Loresta EP (MCP-T360, Dia Instruments Co., Ltd.) and the specific resistivity was calculated and found to be 0.9 kΩcm or less. Also, composition analysis using ICP emission spectrometry was performed for all of the oxide-sintered bodies, and it was found that they had a formulated composition (composition based on the mixture ratio of raw material powders).

Furthermore, endurance testing was performed similar to as was done for examples 1 to 5, and Reference Example 6 for 20 tablets, and it was found that five of the tablets had cracking. This kind of tablet cannot be used to form film stably at high speed. The measurement results are shown in Table 1.

### (Comparative Example 3) Manufacturing In-W-O type oxide-sintered-body tablets having a metallic phase (6.7 g/cm³) using hot press sintering

Except for a sintering temperature of 1000 °C, sintering time of 1 hour and a sintering pressure of 14.70 MPa, oxide-sintered-body tablets were manufactured under the same conditions as examples 1 to and Reference Example 6 using a hot press sintering method, and the density was 6.6 g/cm³. The measurement results are shown in Table 1.

The obtained oxide-sintered body was ground into powder in a mortar, and by performing powder X-ray diffraction measurement using a CuKα ray was found to be structured with a bixbite indium oxide crystal phase (phase listed as 6-416 in the JCPDS card) and a metallic indium crystal phase (phase listed as 5-642 in the JCPDS card). Also, in order to investigate the composition distribution of the oxide-sintered body, surface analysis by EPMA was performed for the surface of a fractured section, and the existence of oxygen was found, and most was in the oxide phase, however, a metallic phase in which no oxygen existed was also found. Therefore, it was considered that tungsten was contained in solid solution in the indium-oxide crystal phase. Also, the metallic phase existed at a size of 10 to 500 µm with the main component being metallic indium, and was the metallic indium crystal phase that was found by the aforementioned X-ray diffraction measurement.

After observation of the surface of the fractured section of the oxide-sintered body with a scanning electron microscope (S-800, Hitachi, Ltd.), the average value of the crystal grain size of 100 crystals from the oxide-sintered body was found, and in each case was 4 to 9 µm. Also, the surface resistance of the circular electron-beam irradiation surface on the oxide-sintered body was measured using a 4-pin probe resistivity meter Loresta EP (MCP-T360, Dia Instruments Co., Ltd.) and the specific resistivity was calculated and found to be 0.4 kΩcm or less. Also, composition analysis using ICP emission spectrometry was performed for all of the oxide-sintered bodies, and it was found that they had a formulated composition (composition based on the mixture ratio of raw material powders).

Furthermore, endurance testing was performed similar to as was done for examples 1 to 5, and Reference Example 6 for 20 tablets, and it was found that 16 of the tablets had cracking. This kind of tablet cannot be used to form film stably at high speed. The measurement results are shown in Table 1.

**[Table 1]**

| | W/In Atomic ratio | Sintering temperature | Sintering time | Sintering pressure | Density of sintered body |
|---|---|---|---|---|---|
| | | (°C) | (h) | (MPa) | (g/cm³) |
| Ex-1 | 0.006 | 700 | 1 | 19.60 | 4.1 |
| Ex-2 | 0.006 | 700 | 1 | 29.40 | 4.7 |
| Ex-3 | 0.006 | 750 | 1 | 14.70 | 5.1 |
| Ex-4 | 0.006 | 800 | 1 | 14.70 | 5.4 |
| Ex-5 | 0.006 | 850 | 1 | 4.91 | 5.9 |
| Re-6 | 0.006 | 900 | 1 | 2.45 | 6.4 |
| Ce-1 | 0.006 | 700 | 0.5 | 4.91 | 3.8 |
| Ce-2 | 0.006 | 900 | 3 | 29.40 | 6.7 |
| Ce-3 | 0.006 | 1000 | 1 | 14.70 | 6.6 |

| | Metallic phase | Defects in Endurance test | | | |
|---|---|---|---|---|---|
| Ex-1 | No | 0 | | | |
| Ex-2 | No | 0 | | | |
| Ex-3 | No | 0 | | | |
| Ex-4 | No | 0 | | | |
| Ex-5 | No | 0 | | | |
| Re-6 | No | 0 | | | |
| Ce-1 | No | 20 | | | |
| Ce-2 | No | 5 | | | |
| Ce-3 | Found | 16 | | | |

| | | | | | |
|---|---|---|---|---|---|
| (Ex=Example, Ce=Comparative Example, Re=Reference Example) | | | | | |

### (Examples 7 to 11) Manufacturing In-W-Zn-O type oxide-sintered-body tablets by atmospheric pressure sintering

In₂O₃ powder having an average grain size of 1 µm or less, WO₃ powder having an average grain size of 1 µm or less, and ZnO powder having an average grain size of 1 µm or less were used as raw materials, and the In₂O₃ powder, WO₃ powder and ZnO powder were prepared in a ratio so that the atomic ratio W/In was 0.006, and the atomic ratio Zn/In was 0.00018 to 0.017, then placed in a plastic pot and mixed using a wet ball mill. When doing this a hard ZrO₂ ball was used and the mixing time was 18 hours. After mixing, the slurry was removed, filtrated, dried and granulated.

A cold isostatic press was used to apply a pressure of 294 MPa (3 ton/cm²) to the granulated material, and the material was formed into a compact.

Next, the compact was sintered as described below. Sintering was performed for 2 hours at 1100 °C in an atmosphere in which oxygen was introduced at a rate of 5L/min per 0.1 m³ of the furnace volume (atmospheric pressure sintering). When doing this, the temperature was raised at 1 °C/min, and when cooling after sintering, the introduction of oxygen was stopped and the temperature was lowered to 1000 °C at a decreasing rate of 10 °C/min.

The obtained oxide-sintered-body tablet was processed into a cylindrical shape having a 30 mm diameter and 40 mm thickness, after which the volume and mass were measured to calculate the density. Oxide-sintered-body tablets having various densities were manufactured by changing the sintering temperature and sintering time. The density of the oxide-sintered-body tablets ranged from 4.4 to 5.8 g/cm³. The measurement results are shown in Table 2.

The obtained oxide-sintered body was ground into powder in a mortar, and by performing powder X-ray diffraction measurement using a CuKα ray was found to be structured with a single bixbite indium oxide crystal phase (phase listed as 6-416 in the JCPDS card). Also, in order to investigate the composition distribution of the oxide-sintered body, surface analysis by EPMA was performed for the surface of a fractured section, and it was found that tungsten, zinc and indium were uniformly distributed inside each crystal grain. Therefore, it was considered that tungsten and zinc were contained in solid solution in the indium-oxide crystal phase.

After observation of the surface of the fracture section of the oxide-sintered body with a scanning electron microscope (S-800, Hitachi, Ltd.), the average value of the crystal grain size of 100 crystals from the oxide-sintered body was found, and in each case was 2 to 7µm. Also, the surface resistance of the circular electron-beam irradiation surface on the oxide-sintered body was measured using a 4-pin probe resistivity meter Loresta EP (MCP-T360, Dia Instruments Co., Ltd.) and the specific resistivity was calculated and found to be 1 kΩcm or less. Also, composition analysis using ICP emission spectrometry was performed for all of the oxide-sintered bodies, and it was found that they had a formulated composition (composition based on the mixture ratio of raw material powders).

Endurance testing was performed under the same conditions as in the case for examples 1 to 5, and Reference Example 6. Endurance testing was performed under the above conditions for 20 tablets of each example 7 to 11, and it was found that none of the tablets broke or had cracking. This kind of tablet can be used to form film stably at high speed. The measurement results are shown in Table 2.

By mixing in Zn at an atomic ratio Zn/In of 0.00018 to 0.017, sinterability is improved, and in this invention, it is possible to achieve the prescribed sintered body density (4.0 to 6.5 g/cm³) at a lower temperature than when Zn is not contained.

This result is the same even when the composition is such that the W/In atomic ratio is 0.001, 0.025, or 0.034. From this result, sinterability can be said to be improved when Zn is contained at a Zn/In atomic ratio of 0.00018 to 0.017.

### (Comparative Example 4) Manufacturing In-W-Zn-O type oxide-sintered-body tablets (3.7g/cm³) by atmospheric pressure sintering

Except that the amount of ZnO in the preparation of raw material power was shifted so that the atomic ratio of Zn/In was 0.00015, oxide-sintered-body tablets were manufactured using a by atmospheric pressure sintering under the same conditions as in examples 7 to 11, and the density was 3.7 g/cm³. The measurement results are shown in Table 2.

The obtained oxide-sintered body was ground into powder in a mortar, and by performing powder X-ray diffraction measurement using a CuKα ray was found to be structured with a single bixbite indium oxide crystal phase (phase listed as 6-416 in the JCPDS card). Also, in order to investigate the composition distribution of the oxide-sintered body, surface analysis by EPMA was performed for the surface of a fractured section, and it was found that tungsten, zinc and indium were uniformly distributed inside each crystal grain. Therefore, it was considered that tungsten and zinc were contained in solid solution in the indium-oxide crystal phase.

After observation of the surface of the fractured section of the oxide-sintered body with a scanning electron microscope (S-800, Hitachi, Ltd.), the average value of the crystal grain size of 100 crystals from the oxide-sintered body was found, and in each case was 2 to 7µm. Also, the surface resistance of the circular electron-beam irradiation surface on the oxide-sintered body was measured using a 4-pin probe resistivity meter Loresta EP (MCP-T360, Dia Instruments Co., Ltd.) and the specific resistivity was calculated and found to be 1 kΩcm or less. Also, composition analysis using ICP emission spectrometry was performed for all of the oxide-sintered bodies, and it was found that they had a formulated composition (composition based on the mixture ratio of raw material powders).

Endurance testing was performed under the same conditions as in the case for examples 1 to 5, and Reference Example 6. Endurance testing was performed under the above conditions for 20 tablets, and it was found that there was breakage in all tablets. This kind of tablet cannot be used to form film stably at high speed. The measurement results are shown in Table 2.

### (Comparative Example 5) Manufacturing In-W-O type oxide-sintered-body tablets (3.2 g/cm³) by atmospheric pressure sintering

In₂O₃ powder having an average grain size of 1 µm or less, and WO₃ powder having an average grain size of 1 µm or less were used as raw materials, and the In₂O₃ powder and WO₃ powder were prepared in a ratio so that the atomic ratio W/In was 0.006, then the materials were placed in a plastic pot and mixed using a wet ball mill. When doing this a hard ZrO₂ ball was used and the mixing time was 18 hours. After mixing, the slurry was removed, filtrated, dried and granulated.

A cold isostatic press was used to apply a pressure of 294 MPa (3 ton/cm²) to the granulated material, and the material was formed into a compact.

Next, the compact was sintered as described below. Sintering was performed for 2 hours at 1100 °C in an atmosphere in which oxygen was introduced at a rate of 5L/min per 0.1 m³ of the furnace volume (atmospheric pressure sintering). When doing this, the temperature was raised at 1 °C/min, and when cooling after sintering, the introduction of oxygen was stopped and the temperature was lowered to 1000 °C at a decreasing rate of 10 °C/min.

The obtained oxide-sintered-body tablet was processed into a cylindrical shape having a 30 mm diameter and 40 mm thickness, after which the volume and mass were measured to calculate the density. The density of the obtained oxide-sintered-body tablets was 3.2 g/cm³. The measurement results are shown in Table 2.

The obtained oxide-sintered body was ground into powder in a mortar, and by performing powder X-ray diffraction measurement using a CuKα ray was found to be structured with a single bixbite indium oxide crystal phase (phase listed as 6-416 in the JCPDS card). Also, in order to investigate the composition distribution of the oxide-sintered body, surface analysis by EPMA was performed for the surface of a fractured section, and it was found that tungsten and indium were uniformly distributed inside each crystal grain. Therefore, it was considered that tungsten was contained in solid solution in the indium-oxide crystal phase.

After observation of the surface of the fractured section of the oxide-sintered body with a scanning electron microscope (S-800, Hitachi, Ltd.), the average value of the crystal grain size of 100 crystals from the oxide-sintered body was found, and in each case was 2 to 8µm. Also, the surface resistance of the circular electron-beam irradiation surface on the oxide-sintered body was measured using a 4-pin probe resistivity meter Loresta EP (MCP-T360, Dia Instruments Co., Ltd.) and the specific resistivity was calculated and found to be 1 kΩcm or less. Also, composition analysis using ICP emission spectrometry was performed for all of the oxide-sintered bodies, and it was found that they had a formulated composition (composition based on the mixture ratio of raw material powders).

Furthermore, endurance testing was performed under the same conditions as in the case for examples 1 to 5, and Reference Example 6. Endurance testing was performed for 20 tablets, and it was found that there was cracking in all of the tablets. This kind of tablet cannot be used to form film stably at high speed. The measurement results are shown in Table 2.

### (Comparative Example 6) Manufacturing In-W-O type oxide-sintered-body tablets (3.4 to 3.8 g/cm³) by atmospheric pressure sintering

Except for a sintering temperature of 1150 to 1250 °C and sintering time of 1 to 5 hours, oxide-sintered-body tablets were manufactured by atmospheric pressure sintering under the same conditions as comparative example 5, and the density was 3.4 to 3.8 g/cm³. The measurement results are shown in Table 2.

Therefore, when ZnO is not contained, it is considered to be impossible to obtain a sintered body having a density of 4.0 g/cm³ or greater by atmospheric pressure sintering at a sintering temperature of 1250 °C or less.

The obtained oxide-sintered body was ground into powder in a mortar, and by performing powder X-ray diffraction measurement using a CuKα ray was found to be structured with a single bixbite indium oxide crystal phase (phase listed as 6-416 in the JCPDS card). Also, in order to investigate the composition distribution of the oxide-sintered body, surface analysis by EPMA was performed for the surface of a fractured section, and it was found that tungsten and indium were uniformly distributed inside each crystal grain. Therefore, it was considered that tungsten was contained in solid solution in the indium-oxide crystal phase.

After observation of the surface of the fractured section of the oxide-sintered body with a scanning electron microscope (S-800, Hitachi, Ltd.), the average value of the crystal grain size of 100 crystals from the oxide-sintered body was found, and in each case was 2 to 7µm. Also, the surface resistance of the circular electron-beam irradiation surface on the oxide-sintered body was measured using a 4-pin probe resistivity meter Loresta EP (MCP-T360, Dia Instruments Co., Ltd.) and the specific resistivity was calculated and found to be 1 kΩcm or less. Also, composition analysis using ICP emission spectrometry was performed for all of the oxide-sintered bodies, and it was found that they had a formulated composition (composition based on the mixture ratio of raw material powders).

Furthermore, endurance testing was performed under the same conditions as in the case for examples 1 to 5, and Reference Example 6. Endurance testing was performed for 20 tablets, and it was found that there was breakage of all of the tablets. This kind of tablet cannot be used to form film stably at high speed. The measurement results are shown in Table 2.

This tendency was exactly the same as in the case of manufacturing an oxide-sintered-body tablets having a composition (W/In atomic ratio, Zn/In atomic ratio) of (0.001, 0), (0.025, 0) and (0.034, 0).

### (Example 12) Manufacturing of In-W-O type oxide-sintered-body tablets (4.1 g/cm³) by atmospheric pressure sintering

Except for a sintering temperature of 1300 °C and sintering time of 5 hours, oxide-sintered-body tablets were manufactured by atmospheric pressure sintering under the same conditions as comparative example 5, and the density was 4.1 g/cm³. The measurement results are shown in Table 2.

Therefore, when ZnO is not contained, the conditions of high sintering temperature of 1300 °C and long sintering period of 5 hours are necessary to obtain a sintered body having a density of 4.0 g/cm³ or greater by atmospheric pressure sintering.

The obtained oxide-sintered body was ground into powder in a mortar, and by performing powder X-ray diffraction measurement using a CuKα ray was found to be structured with a single bixbite indium oxide crystal phase (phase listed as 6-416 in the JCPDS card). Also, in order to investigate the composition distribution of the oxide-sintered body, surface analysis by EPMA was performed for the surface of a fractured section, and it was found that tungsten and indium were uniformly distributed inside each crystal grain. Therefore, it was considered that tungsten was contained in solid solution in the indium-oxide crystal phase.

After observation of the surface of the fracture section of the oxide-sintered body with a scanning electron microscope (S-800, Hitachi, Ltd.), the average value of the crystal grain size of 100 crystals from the oxide-sintered body was found, and in each case was 2 to 7µm. Also, the surface resistance of the circular electron-beam irradiation surface on the oxide-sintered body was measured using a 4-pin probe resistivity meter Loresta EP (MCP-T360, Dia Instruments Co., Ltd.) and the specific resistivity was calculated and found to be 1 kΩcm or less. Also, composition analysis using ICP emission spectrometry was performed for all of the oxide-sintered bodies, and it was found that they had a formulated composition (composition based on the mixture ratio of raw material powders).

Furthermore, endurance testing was performed under the same conditions as in the case for examples 1 to 5, and Reference Example 6. Endurance testing was performed for 20 tablets, and it was found that there was no breakage or cracking of any of the tablets. This kind of tablet can be used to form film stably at high speed. The measurement results are shown in Table 2.

This tendency was exactly the same as in the case of manufacturing an oxide-sintered-body tablets having a composition (W/In atomic ratio, Zn/In atomic ratio) of (0.001, 0), (0.025, 0) and (0.034, 0). Therefore, even when ZnO is not contained, by atmospheric pressure sintering with conditions of 1300 °C and 5 hours, it is possible to obtain a sintered body having a density of 4.0 to 4.2 g/cm³ and having no cracking when evaluated by endurance testing.

### (Examples 13 to 17, and Reference Example 18) Manufacturing In-W-Zn-O type oxide-sintered-body tablets (4.2 to 6.5 g/cm³) by atmospheric pressure sintering

In₂O₃ powder having an average grain size of 1 µm or less, WO₃ powder having an average grain size of 1 µm or less, and ZnO powder having an average grain size of 1 µm or less were used as raw materials, and the In₂O₃ powder, WO₃ powder and ZnO powder were prepared so that the atomic ratio W/In was 0.012, and the atomic ratio Zn/In was 0.008, the materials where then placed in a plastic pot and mixed using a wet ball mill. When doing this a hard ZrO₂ ball was used and the mixing time was 18 hours. After mixing, the slurry was removed, filtrated, dried and granulated.

A cold isostatic press was used to apply a pressure of 294 MPa (3 ton/cm²) to the granulated material, and the material was formed into a compact.

Next, the compact was sintered as described below. Sintering was performed at atmospheric pressure for 1 to 2 hours at 1000 °C to 1200 °C in an atmosphere in which oxygen was introduced at a rate of 5L/min per 0.1 m³ of the furnace volume. When doing this, the temperature was raised at 1 °C/min, and when cooling after sintering, the introduction of oxygen was stopped and the temperature was lowered to 1000 °C at a decreasing rate of 10 °C/min.

The obtained oxide-sintered-body tablet was processed into a cylindrical shape having a 30 mm diameter and 40 mm thickness, after which the volume and mass were measured to calculate the density. Oxide-sintered-body tablets having various densities were manufactured by changing the sintering temperature and sintering time. The density of the oxide-sintered-body tablets ranged from 4.2 to 6.5 g/cm³. The measurement results are shown in Table 2.

The obtained oxide-sintered body was ground into powder in a mortar, and by performing powder X-ray diffraction measurement using a CuKα ray was found to be structured with a single bixbite indium oxide crystal phase (phase listed as 6-416 in the JCPDS card). Also, in order to investigate the composition distribution of the oxide-sintered body, surface analysis by EPMA was performed for the surface of a fractured section, and it was found that tungsten, zinc and indium were uniformly distributed inside each crystal grain. Therefore, it was considered that tungsten and zinc were contained in solid solution in the indium-oxide crystal phase.

After observation of the surface of the fractured section of the oxide-sintered body with a scanning electron microscope (S-800, Hitachi, Ltd.), the average value of the crystal grain size of 100 crystals from the oxide-sintered body was found, and in each case was 1 to 9µm. Also, the surface resistance of the circular electron-beam irradiation surface on the oxide-sintered body was measured using a 4-pin probe resistivity meter Loresta EP (MCP-T360, Dia Instruments Co., Ltd.) and the specific resistivity was calculated and found to be 0.9 kΩcm or less. Also, composition analysis using ICP emission spectrometry was performed for all of the oxide-sintered bodies, and it was found that they had a formulated composition (composition based on the mixture ratio of raw material powders).

Endurance testing was performed under the same conditions as in the case for examples 1 to 5, and Reference Example 6. Endurance testing was performed under the above conditions for 20 tablets of each example 13 to 18, and it was found that none of the tablets broke or had cracking. This kind of tablet can be used to form film stably at high speed. The measurement results are shown in Table 2.

Using the obtained oxide-sintered-body tablet, film formation was performed using the aforementioned magnetic-field-deflection type electron beam evaporation apparatus. The film was formed on a glass substrate (1.1 mm thick Coming 7059) for just the amount of time calculated from the respective film-formation speed so that the thickness of each film becomes 200 nm, and thin film was manufactured. The glass substrate was not heated.

As in the case of examples 1 to 5, and Reference Example 6, the specific resistivity, transmittance of the film itself, surface roughness (Ra) and crystallinity were evaluated.

As a result, in all of the obtained thin films it was found that the specific resistivity was 3.2 x 10⁻⁴ to 8 x 10⁻⁴ Ωcm or less, the average transmittance of the film itself in the visible range (400 to 800 nm) was 82 to 89%, the average transmittance of the film itself in the near infrared range of 900 to 1100 nm was 61 to 75%, the centerline average surface roughness (Ra) on the film surface was 1.7 nm or less, and the film was non crystalline. Film having these characteristics is useful as a transparent electrode of display elements such as an organic EL or LCD. The composition of the film was nearly the same as the composition of the oxide-sintered-body tablet.

Also, this film was annealed for 1 hour at 230 °C in a nitrogen atmosphere, and similarly the characteristics were evaluated. The annealed film was found through X-ray diffraction measurement to be an indium-oxide crystal film having bixbite type structure. As a result, the film had good light transmission in the near infrared range as well as in the visible light range, the transmittance became good, where the average transmittance of the film itself in the visible range (400 to 800 nm) became 87 to 91%, and in the near infrared range of 900 to 1100 nm became 80 to 86%. Also, the specific resistivity of the film was 4.2 x 10⁻⁴ to 7 x 10⁻⁴ Ωcm. By using this kind of oxide-transparent-conductive film for a transparent electrode of a solar battery, it is possible to effectively use near infrared energy as well, so it is useful.

### (Comparative Example 7) Manufacturing In-W-Zn-O type oxide-sintered-body tablets (3.8 g/cm³) by atmospheric pressure sintering

Except for a sintering time of 0.5 hours, oxide-sintered-body tablets were manufactured under the same conditions as example 13, and the density was 3.8 g/cm³. The measurement results are shown in Table 2.

The oxide-sintered body was ground into powder in a mortar, and by performing powder X-ray diffraction measurement using a CuKα ray was found to be structured with a single bixbite indium oxide crystal phase (phase listed as 6-416 in the JCPDS card). Also, in order to investigate the composition distribution of the oxide-sintered body, surface analysis by EPMA was performed for the surface of a fractured section, and it was found that tungsten, zinc and indium were uniformly distributed inside each crystal grain. Therefore, it was considered that tungsten and zinc were contained in solid solution in the indium-oxide phase.

After observation of the surface of the fractured section of the oxide-sintered body with a scanning electron microscope (S-800, Hitachi, Ltd.), the average value of the crystal grain size of 100 crystals from the oxide-sintered body was found, and in each case was 1 to 9µm. Also, the surface resistance of the circular electron-beam irradiation surface on the oxide-sintered body was measured using a 4-pin probe resistivity meter Loresta EP (MCP-T360, Dia Instruments Co., Ltd.) and the specific resistivity was calculated and found to be 0.9 kΩcm or less. Also, composition analysis using ICP emission spectrometry was performed for all of the oxide-sintered bodies, and it was found that they had a formulated composition (composition based on the mixture ratio of raw material powders).

Furthermore, endurance testing was performed under the same conditions as in the case for examples 1 to 5, and Reference Example 6. Endurance testing was performed for 20 tablets, and it was found that all of the tablets broke. This kind of tablet cannot be used to form film stably at high speed. The measurement results are shown in Table 2.

### (Comparative Example 8) Manufacturing In-W-Zn-O type oxide-sintered-body tablets (6.8 g/cm³) by atmospheric pressure sintering

Except for a sintering temperature of 1200 °C and a sintering time of 4 hours, oxide-sintered-body tablets were manufactured under the same conditions as Reference Example 18, and the density was 6.8 g/cm³. The measurement results are shown in Table 2.

The obtained oxide-sintered body was ground into powder in a mortar, and by performing powder X-ray diffraction measurement using a CuKα ray was found to be structured with a single bixbite indium oxide crystal phase (phase listed as 6-416 in the JCPDS card). Also, in order to investigate the composition distribution of the oxide-sintered body, surface analysis by EPMA was performed for the surface of a fractured section, and it was found that tungsten, zinc and indium were uniformly distributed inside each crystal grain. Therefore, it was considered that tungsten and zinc were contained in solid solution in the indium-oxide phase.

After observation of the surface of the fractured section of the oxide-sintered body with a scanning electron microscope (S-800, Hitachi, Ltd.), the average value of the crystal grain size of 100 crystals from the oxide-sintered body was found, and in each case was 1 to 9µm. Also, the surface resistance of the circular electron-beam irradiation surface on the oxide-sintered body was measured using a 4-pin probe resistivity meter Loresta EP (MCP-T360, Dia Instruments Co., Ltd.) and the specific resistivity was calculated and found to be 0.9 kΩcm or less. Also, composition analysis using ICP emission spectrometry was performed for all of the oxide-sintered bodies, and it was found that they had a formulated composition (composition based on the mixture ratio of raw material powders).

Furthermore, endurance testing was performed under the same conditions as in the case for examples 1 to 5, and Reference Example 6. Endurance testing was performed for 20 tablets, and it was found that five of the tablets had cracking. This kind of tablet cannot be used to form film stably at high speed. The measurement results are shown in Table 2.

### (Comparative Example 9) Manufacturing In-W-Zn-O type oxide-sintered-body tablets (6.2 g/cm³, with metallic phase) by atmospheric pressure sintering

Except for not introducing oxygen into the sintering furnace during sintering, oxide-sintered-body tablets were manufactured by atmospheric pressure sintering under the same conditions as example 17, and the density was 6.2 g/cm³. The measurement results are shown in Table 2.

The obtained oxide-sintered body was ground into powder in a mortar, and by performing powder X-ray diffraction measurement using a CuKα ray was found to be structured with a bixbite indium oxide crystal phase (phase listed as 6-416 in the JCPDS card) and a metallic indium crystal phase (phase listed as 5-642 in the JCPDS card). Also, in order to investigate the composition distribution of the oxide-sintered body, surface analysis by EPMA was performed for the surface of a fractured section, and the existence of oxygen was found, and most was in the oxide phase, however, a metallic phase in which no oxygen existed was also found. It was found that tungsten, zinc and indium were uniformly distributed inside the oxide phase. Therefore, it was considered that tungsten and zinc were contained in solid solution in the indium-oxide crystal phase. Also, the metallic phase existed at a size of 20 to 400 µm with the main component being metallic indium with a small amount of solid solution zinc, and was the metallic indium crystal phase that was found by the aforementioned X-ray diffraction measurement.

After observation of the surface of the fractured section of the oxide-sintered body with a scanning electron microscope (S-800, Hitachi, Ltd.), the average value of the crystal grain size of 100 crystals from the oxide-sintered body was found, and in each case was 4 to 9 µm. Also, the surface resistance of the circular electron-beam irradiation surface on the oxide-sintered body was measured using a 4-pin probe resistivity meter Loresta EP (MCP-T360, Dia Instruments Co., Ltd.) and the specific resistivity was calculated and found to be 0.5 kΩcm or less. Also, composition analysis using ICP emission spectrometry was performed for all of the oxide-sintered bodies, and it was found that they had a formulated composition (composition based on the mixture ratio of raw material powders).

Furthermore, endurance testing was performed similar to as was done for examples 1 to 5, and Reference Example 6 for 20 tablets, and it was found that 15 of the tablets had cracking. This kind of tablet cannot be used to form film stably at high speed. The measurement results are shown in Table 2.

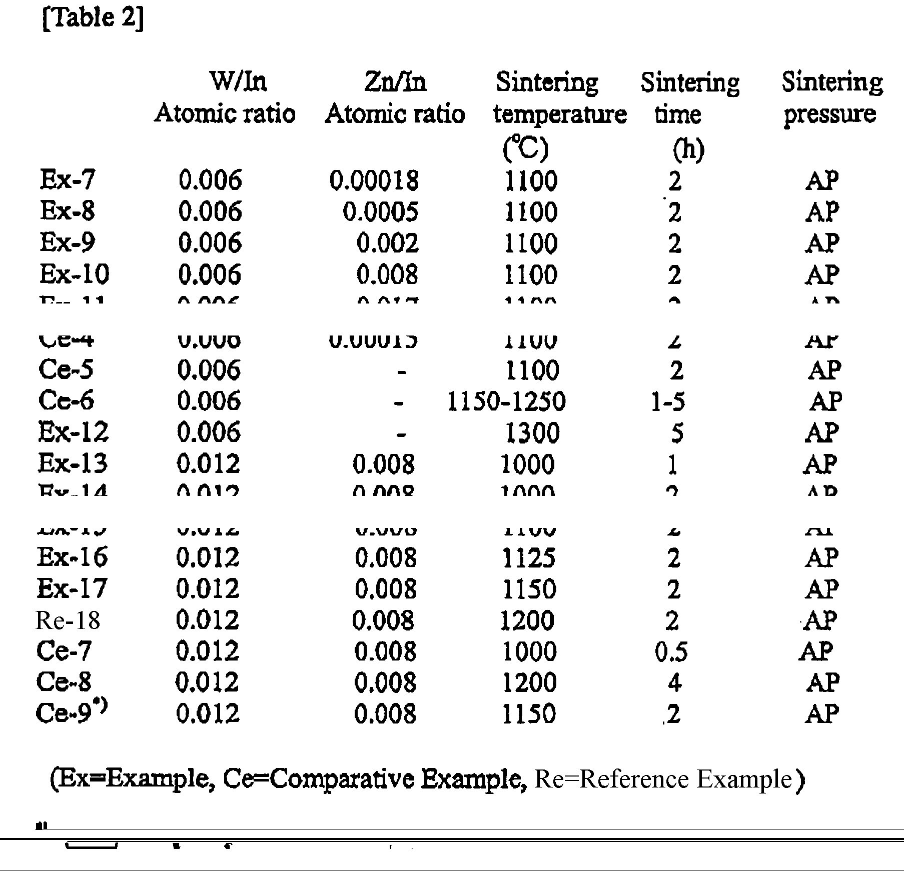

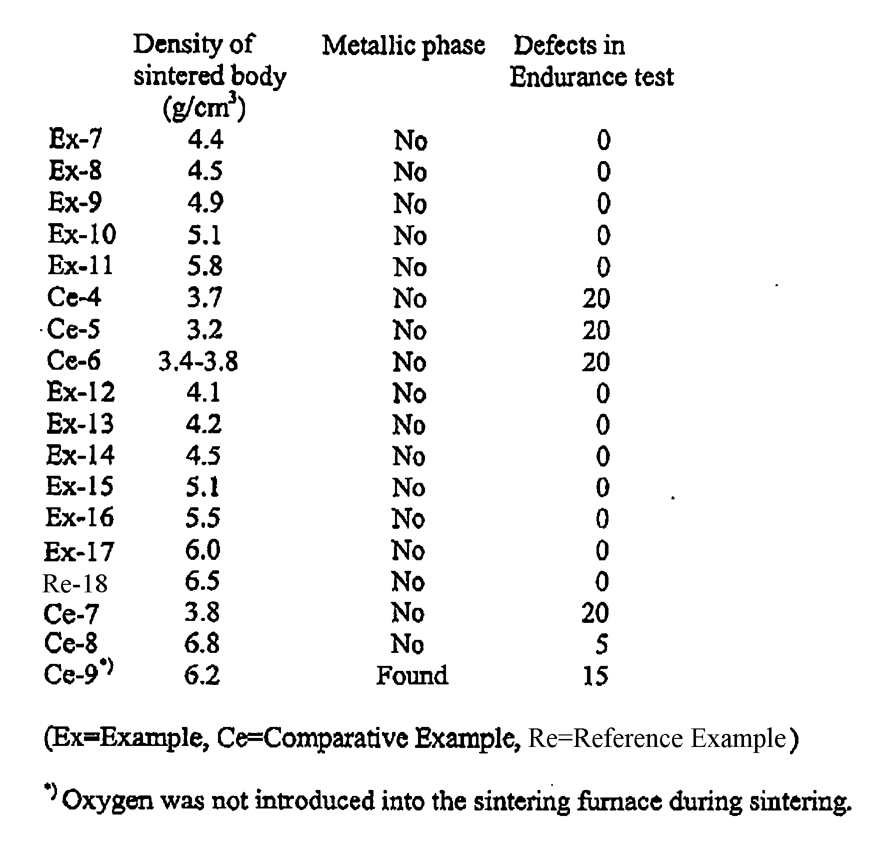

### (Example 19)

Oxide-sintered-body tablets for evaporation having various densities were manufactured under various sintering conditions using a hot press sintering method similar to as was done for examples 1 to 5, and Reference Example 6 so that the compositions of the oxide-sintered-body tablets (W/In atomic ratio, Zn/In atomic ratio) were (0.001, 0), (0.025, 0), (0.034, 0), and the durability was similarly examined by electronic-beam irradiation.

The results showed the exact same tendencies, and when the density of the oxide-sintered-body tablets was 4.0 to 6.5 g/cm³, it was possible to use the tablets stably with no breakage or cracking.

Also, oxide-sintered-body tablets for evaporation having various densities were manufactured under various sintering conditions by atmospheric pressure sintering similar to as was done for examples 13 to 17, and Reference Example 18 so that the compositions of the oxide-sintered-body tablets (W/In atomic ratio, Zn/In atomic ratio) were (0.001, 0.001), (0.025, 0.008), (0.034, 0.017), and the durability was similarly examined by electronic-beam irradiation.

The results showed the exact same tendencies, and when the density of the oxide-sintered-body tablets was 4.0 to 6.5 g/cm³, it was possible to use the tablets stably with no breakage or cracking.

The oxide-sintered bodies were ground into powder in a mortar, and by performing powder X-ray diffraction measurement using a CuKα ray was found to be structured with a single bixbite indium oxide crystal phase (phase listed as 6-416 in the JCPDS card). Also, in order to investigate the composition distribution of the oxide-sintered body, surface analysis by EPMA was performed for the surface of a fractured section, and it was found that each of the metallic elements wes uniformly distributed inside each crystal grain.

After observation of the surface of the fractured section of the oxide-sintered body with a scanning electron microscope (S-800, Hitachi, Ltd.), the average value of the crystal grain size of 100 crystals from the oxide-sintered body was found, and in each case was 1 to 9 µm. Also, the surface resistance of the circular electron-beam irradiation surface on the oxide-sintered body was measured using a 4-pin probe resistivity meter Loresta EP (MCP-T360, Dia Instruments Co., Ltd.) and the specific resistivity was calculated and found to be 0.8 kΩcm or less. Also, composition analysis using ICP emission spectrometry was performed for all of the oxide-sintered bodies, and it was found that they had a formulated composition (composition based on the mixture ratio of raw material powders).

Using the obtained oxide-sintered-body tablet, film formation was performed using the aforementioned magnetic-field-deflection type electron beam evaporation apparatus as in the case of examples 1 to 5, and Reference Example 6. The film was formed on a glass substrate (1.1 mm thick Coming 7059) for just the amount of time calculated from the respective film-formation speed so that the thickness of each film becomes 200 nm, and thin film was manufactured. The glass substrate was not heated.

As in the case of examples 1 to 5, and Reference Example 6, the specific resistivity, transmittance of the film itself, surface roughness (Ra) and crystallinity were evaluated.

As a result, in all of the obtained thin films it was found that the specific resistivity was 2.1 x 10⁴ to 9 x 10⁻⁴ Ωcm, the average transmittance of the film itself in the visible range (400 to 800 nm) was 85 to 90%, the average transmittance of the film itself in the near infrared range of 900 to 1100 nm was 63 to 73%, the centerline average surface roughness (Ra) on the film surface was 1.6 nm or less, and the film was non crystalline. Film having these characteristics is useful as a transparent electrode of display elements such as an organic EL or LCD. The composition of the film was nearly the same as the composition of the oxide-sintered-body tablet.

Also, this film was annealed for 1 hour at 200 to 400 °C in a nitrogen atmosphere, and similarly the characteristics were evaluated. The annealed film was found through X-ray diffraction measurement to be an indium-oxide crystal film having bixbite type structure. As a result, the film had good light transmission in the near infrared range as well as in the visible light range, the transmittance became good, where the average transmittance of the film itself in the visible range (400 to 800 nm) became 88 to 92%, and in the near infrared range of 900 to 1100 nm became 80 to 90%. Also, the specific resistivity of the film was 1.9 x 10⁻⁴ to 8.5 x 10⁻⁴ Ωcm. By using this kind of oxide-transparent-conductive film for a transparent electrode of a solar battery, it is possible to effectively use near infrared energy as well, so it is useful.

### (Comparative Example 10)

Except for used In₂O₃ powder having an average grain size of about 10 µm, oxide-sintered-body tablets were manufactured under the same conditions as example 3, and the density was 4.5 g/cm³. Also, the surface resistance of the circular electron-beam irradiation surface on the oxide-sintered body was measured using a 4-pin probe resistivity meter Loresta EP (MCP-T360, Dia Instruments Co., Ltd.) and the specific resistivity was calculated and found to be 0.9 kΩcm or less.

The obtained oxide-sintered body was ground into powder in a mortar, and by performing powder X-ray diffraction measurement using a CuKα ray was found to be structured with a single bixbite indium oxide crystal phase (phase listed as 6-416 in the JCPDS card). Also, in order to investigate the composition distribution of the oxide-sintered body, surface analysis by EPMA was performed for the surface of a fractured section, and it was found that each of the metallic elements was uniformly distributed inside each crystal grain. Also, composition analysis using ICP emission spectrometry was performed for all of the oxide-sintered bodies, and it was found that they had a formulated composition (composition based on the mixture ratio of raw material powders).

After observation of the surface of the fractured section of the oxide-sintered body with a scanning electron microscope (S-800, Hitachi, Ltd.), the average value of the crystal grain size of 100 crystals from the oxide-sintered body was found to be 21 µm, which was larger than that of examples 1 to 15 (10 µm or less).

Endurance testing was performed under the same conditions as that performed in examples 1 to 5, and Reference Example 6 for 20 of the oxide-sintered-body tablets having this kind of large average crystal grain size, and there was cracking in two of the tablets. Therefore it was found that this kind of tablet cannot be used for forming film stably at high speed.

### (Comparative Example 11) Specific resistivity of 2.5 kΩcm

When manufacturing oxide-sintered-body tablets having a composition (W/In atomic ratio, Zn/In atomic ratio) of (0.018, 0.008), except for lowering the temperature when cooling after atmospheric pressure sintering while maintaining the introduction of oxygen into the sintering furnace at 5 L/min, the oxide-sintered-body tablets were manufactured under the same conditions as Example 14, and the density was 4.7 g/cm³.

The obtained oxide-sintered body was ground into powder in a mortar, and by performing powder X-ray diffraction measurement using a CuKα ray was found to be structured with a single bixbite indium oxide crystal phase (phase listed as 6-416 in the JCPDS card). Also, in order to investigate the composition distribution of the oxide-sintered body, surface analysis by EPMA was performed for the surface of a fractured section, and it was found that each of the metallic elements was uniformly distributed inside each crystal grain. Also, composition analysis using ICP emission spectrometry was performed for all of the oxide-sintered bodies, and it was found that they had a formulated composition (composition based on the mixture ratio of raw material powders).

After observation of the surface of the fractured section of the oxide-sintered body with a scanning electron microscope (S-800, Hitachi, Ltd.), the average value of the crystal grain size of 100 crystals from the oxide-sintered body was found to be 8 µm. However, the surface resistance of the circular electron-beam irradiation surface on the oxide-sintered body was measured using a 4-pin probe resistivity meter Loresta EP (MCP-T360, Dia Instruments Co., Ltd.) and the specific resistivity was calculated and found to be 2.5 kΩcm, which was high resistance compared with the oxide-sintered bodies of examples 1 to 5, and 7 to 19, and Reference Examples 6 and 18 (1 KΩcm or less).

Endurance test using electronic-beam irradiation was performed under the same conditions as in examples 1 to 5, and Reference Example 6 for the oxlde-sintered-body tablets having this kind of high resistance. In five minutes after starting electron-beam irradiation, the irradiated position of the electron beam was not at a specified location and was unstable. Thus, stable film formation could not be performed. The reason was that since the tablet resistance was high, a build up of charge on the tablet occurred due to the electron-beam irradiation. This kind of tablet cannot be used for forming film stably at high speed.

### (Example 20)

Using the oxide-sintered-body tablets of examples 1 to 5, and 1 to 19, and Reference Examples 6 and 18 and comparative examples 1 to 11, film formation was performed using a high-density plasma assist evaporation method (HDPE method) that uses a plasma gun, and the endurance of the oxide-sintered-body tablets was examined. The results showed the same tendency as the results obtained in examples 1 to 5, and 1 to 19 and Reference Example 6 and 19 and comparative examples 1 to 11, and by using oxide-sintered-body tablets having a density of 4.0 to 6.5 gl/m³, it was found that it was possible to obtain tablets for evaporation in which breakage and cracking did not occur.

As in the case of examples 1 to 5, and Reference Example 6, the specific resistivity, transmittance of the film itself, surface roughness (Ra) and crystallinity were evaluated for the obtained thin film.

As a result, for thin film formed on an unheated glass substrate (1.1 mm thick Coming 7059), it was found that the specific resistivity was 1.8 x 10⁴ to 9 x 10⁻⁴ Ωcm, the average transmittance of the film itself in the visible range (400 to 800 nm) was 85 to 88%, the average transmittance of the film itself in the near infrared range of 900 to 1100 nm was 61 to 75%, the centerline average surface roughness (Ra) on the film surface was 1.6 nm or less, and the film was non crystalline. Film having these characteristics is useful as a transparent electrode of display element such as an organic EL or LCD. The composition of the film was nearly the same as the composition of the oxide-sintered-body tablet.

Also, this film was annealed for 1 hour at 200 to 400°C in a nitrogen atmosphere, and similarly the characteristics were evaluated. The annealed film was found through X-ray diffraction measurement to be an indium-oxide crystal film having bixbite type structure. As a result, the film had good light transmission in the near infrared range as well as in the visible light range, the transmittance became good, where the average transmittance of the film itself in the visible range (400 to 800 nm) became 87 to 91%, and in the near infrared range of 900 to 1100 nm became 80 to 90%. Also, the specific resistivity of the film was 1.8 x 10⁻⁴ to 9.0 x 10⁻⁴ Ωcm. By using this kind of oxide-transparent-conductive film for a transparent electrode of a solar battery, it is possible to effectively use near infrared energy as well, so it is useful.

## Claims

1. An oxide-sintered body for an evaporation source tablet containing indium oxide wherein tungsten is contained in solid solution so that the atomic ratio of tungsten with respect to indium is 0.001 to 0.034, and the density is 4.0 g/cm³ to 5.9 g/cm³, the oxide-sintered body containing no metallic phase and having an average crystal grain size of 10µm or less.

2. An oxide-sintered body for an evaporation source tablet containing indium oxide, wherein tungsten and zinc are contained in solid solution so that the atomic ratio of tungsten with respect to indium is 0.001 to 0.034, the atomic ratio of zinc with respect to indium is 0.00018 to 0.017, and the density is 4.0 g/cm³ to 6.0 g/cm³, the oxide-sintered body containing no metallic phase and halving an average crystal grain size of 10µm or less.

3. The oxide-sintered body for an evaporation source tablet of claim 1 or 2, wherein the specific resistivity is 1 kΩcm or less.

4. A manufacturing method for an oxide-sintered body comprising: a first step of preparing and mixing indium-oxide powder and tungsten-oxide powder so that the atomic ratio of tungsten with respect to indium is 0.001 to 0.034; and a second step of performing hot-press sintering of the compound obtained in the first step process at a temperature of 700 °C to 900 °C, for a period equal to or greater than 1 hour and less than 3 hours, and at a pressure of 2.45 MPa to 29.40 MPa to obtain an oxide-sintered body for an evaporation source tablet containing indium oxide, wherein tungsten is contained in solid solution so that the atomic ratio of tungsten with respect to indium is 0.001 to 0.034, and the density is 4.0 g/cm³ to 5.9 g/cm³, the oxide-sintered body containing no metallic phase and having an average crystal grain size of 10µm or less.

5. A manufacturing method for an oxide-sintered body comprising: a first step of preparing and mixing indium-oxide powder, tungsten-oxide powder and zinc-oxide powder so that the atomic ratio of tungsten with respect to indium is 0.001 to 0.034; and the atomic ratio of zinc with respect to indium is 0.00018 to 0.017; and a second step of performing hot-press sintering of the compound obtained in the first step at a temperature of 700 °C to 900 °C, for a period equal to or greater than 1 hour and less than 3 hours, and at a pressure of 2.45 MPa to 29.40 MPa to obtain an oxide-sintered body for an evaporation source tablet containing indium oxide, wherein tungsten and zinc are contained in solid solution so that the atomic ratio of tungsten with respect to indium is 0.001 to 0.034, the atomic ratio of zinc with respect to indium is 0.00018 to 0.017, and the density is 4.0 g/cm³ to 6.0 g/cm³, the oxide-sintered body containing no metallic phase and having an average crystal grain size of 10µm or less.

6. A manufacturing method for an oxide-sintered body comprising: a first step of preparing and mixing indium-oxide powder and tungsten-oxide powder so that the atomic ratio of tungsten with respect to indium is 0.001 to 0.034; a second step of performing cold isostatic pressing of the compound obtained in the first step at a pressure of 9.8 MPa to 294 MPa to form a compact; and a third step of performing sintering of the compact obtained in the second step in a sintering furnace at atmospheric pressure, at a temperature of 1300 °C or more, for a period of 5 hours or more to obtain an oxide-sintered body for an evaporation source tablet containing indium oxide, wherein tungsten is contained in solid solution so that the atomic ratio of tungsten with respect to indium is 0.001 to 0.034, and the density is 4.0 g/cm³ to 5.9 g/cm³, the oxide-sintered body containing no metallic phase and having an average crystal grain size of 10µm or less.

7. A manufacturing method for an oxide-sintered body comprising: a first step of preparing and mixing indium-oxide powder, tungsten-oxide powder and zinc powder so that the atomic ratio of tungsten with respect to indium is 0.001 to 0.034 and the atomic ratio of zinc with respect to indium is 0.00018 to 0.017; a second step of performing cold isostatic pressing of the compound obtained in the first step at a pressure greater of 9.8 MPa to 294 MPa to form a compact; and a third step of performing sintering of the compact obtained in the second step in a sintering furnace at atmospheric pressure, at a temperature of 1000 °C to 1300 °C, for a period of 1 hour to 5 hours to obtain an oxide-sintered body for an evaporation source tablet containing indium oxide, wherein tungsten and zinc are contained in solid solution so that the atomic ratio of tungsten with respect to indium is 0.001 to 0.034, the atomic ratio of zinc with respect to indium is 0.00018 to 0.017, and the density is 4.0 g/cm³ to 6.0 g/cm³. the oxide-sintered body containing no metallic phase and having an average crystal grain size of 10µm or less.

8. The manufacturing method for an oxide-sintered body according to claim 6 or 7, wherein the sintering process is performed in an atmosphere in which oxygen is introduced into the sintering furnace at a ratio of 3 to 8 L/min per 0.1 m³ of the furnace volume.

9. The manufacturing method for an oxide-sintered body according to claim 8, wherein when cooling the furnace after the sintering process, the introduction of oxygen is stopped.

10. An oxide-transparent-conductive film that is manufactured by a vacuum evaporation method using a tablet which is obtained by precessing of the oxide-sintered body for an evaporation source tablet according to any one of claims 1 to 3, the film being crystalline and having a specific resistivity of 9 x 10⁴ Ωcm or less, average transmittance of the film itself of 82% or greater in light having a wavelength of 400 to 800 nm and 80% or greater in light having a wavelength of 900 to 1100 nm.

11. A method for manufacturing an oxide-transparent-conductive film in which a tablet which is obtained by processing the oxide-sintered body for an evaporation source tablet according to any one of claims 1 to 3 is used, and where after a film is manufactured by vacuum evaporation on a glass substrate at a temperature less than 130 °C or less, the manufactured film is heat treated in inert gas or in a vacuum at 200 to 400 °C.

## Patentansprüche

1. Oxidsinterkörper für eine Verdampfungsquellentablette, der Indiumoxid enthält, wobei Wolfram in fester Lösung enthalten ist, so dass das Atomverhältnis von Wolfram hinsichtlich Indium 0,001 bis 0,034 beträgt und die Dichte 4,0 g/cm³ bis 5,9 g/cm³ beträgt, der Oxidsinterkörper keine metallische Phase enthält und eine mittlere Kristallkorngröße von 10 µm oder weniger aufweist.

2. Oxidsinterkörper für eine Verdampfungsquellentablette, der Indiumoxid enthält, wobei Wolfram und Zink in fester Lösung enthalten sind, so dass das Atomverhältnis von Wolfram hinsichtlich Indium 0,001 bis 0,034 beträgt, das Atomverhältnis von Zink hinsichtlich Indium 0,00018 bis 0,017 beträgt, und die Dichte 4,0 g/cm³ bis 6,0 g/cm³ beträgt, der Oxidsinterkörper keine metallische Phase enthält und eine mittlere Kristallkorngröße von 10 µm oder weniger aufweist,

3. Oxidsinterkörper für eine Verdampfungsquellentablette gemäß Anspruch 1 oder 2, wobei der spezifische Widerstand 1 kΩcm oder weniger beträgt.

4. Herstellungsverfahren für einen Oxidsinterkörper, das folgendes umfasst: einen ersten Schritt des Herstellens und Mischens von Indiumoxidpulver und Wolframoxidpulver, so dass das Atomverhältnis von Wolfram hinsichtlich Indium 0,001 bis 0,034 beträgt; und einen zweiten Schritt des Durchführens von Heißpresssintern der Verbindung, die in dem ersten Schritt erhalten wurde, bei einer Temperatur vorn 700 °C bis 900 °C für einen Zeitraum gleich oder größer als eine Stunde und kleiner als drei Stunden und bei einem Druck von 2,45 MPa bis 29,40 MPa, um einen Oxidsinterkörper für eine Verdampfungsquellentablette, der Indiumoxid enthält, zu erhalten, wobei Wolfram in fester Lösung enthalten ist, so dass das Atomverhältnis von Wolfram hinsichtlich Indium 0,001 bis 0,034 beträgt und die dichte 4,0 g/cm³ bis 5,9 g/cm³ beträgt, der Oxidsinterkörper keine metallische Phase enthält rund eine mittlere Kristallkorngröße von 10 µm oder weniger aufweist,

5. Herstellungsverfahren für Oxidsinterkörper, das folgendes umfasst: einen ersten Schritt des Herstellens und Mischens von Indiumoxidpulver, Wolframoxidpulver und Zinkoxidpulver, so dass das Atomverhältnis von Wolfram hinsichtlich indium 0,001 bis 0,034 und das Atoniverhältnis von Zink hinsichtlich Indium 0,00018 bis 0,017 beträgt; und einen zweiten Schritt des Durchführens von Heißpresssintern der Verbindung, die in dem ersten Schritt erhalten wurde, bei einer Temperatur von 700 °C bis 900°C für einen Zeitraum gleich oder größer als eine Stunde und kleiner als drei Stunden und bei einem Druck von 2,45 MPa bis 29,40 MPa, um einen Oxidsinterkörper für eine Verdampfungsquellentablette, der Indiumoxid enthält, zu erhalten, wobei Wolfram und Zink in fester Lösung enthalten sind, so dass das Atomverhältnis von Wolfram hinsichtlich indium 0,001 bis 0,034 beträgt, das Atomverhältnis von Zink hinsichtlich Indium 0,00018 bis 0,017 beträgt und die dichte 4,0 g/cm³ bis 6,0 g/cm³ beträgt, der Oxidsinterkörper keine metallische Phase enthält und eine mittlere Kristallkorngröße von 10 µm oder weniger aufweiset.

6. Herstellungsverfahren für einen Oxidsinterkörper, das folgendes umfasst: einen ersten Schritt des Herstellens und Mischens von Indiumoxidpulver und Wolframoxidpulver, so dass das Atomverhältnis von Wolfram hinsichtlich indium 0,001 bis 0,034 beträgt; einen zweiten Schritt des Durchführens von kaltem isostatischen Pressen der Verbindung, die in dem ersten Schritt erhalten wurde, bei einem Druck vorn 9,8 MPa bis 294 MPa, µm einen Presskörper zu bilden; und einen dritten Schritt des Durchführens von Sinterung des Presskörpers, der in dem zweiten Schritt erhalten wurde, in einem bei Atmosphärendruck bei einer Temperatur von 1300°C oder mehr für einen Zeitraum von fünf Stunden oder mehr, um einen Oxidsinterkörper für eine Verdampfungsquellentablette, der Indiumoxid enthält, zu erhalten, wobei Wolfram in fester Lösung enthalten ist, so dass das Atomverhältnis von Wolfram hinsichtlich Indium 0,001 bis 0,034 beträgt und die Wichte 4,0 g/cm³ bis 5,9 g/cm³ beträgt, der Oxidsinterkörper keine metallische Phase enthält und eine mittlere Kristallkorngröße von 10 µm oder weniger aufweist.

7. Herstellungsverfahren für einen Oxidsinterkörper, das folgendes umfasst: einen ersten Schritt des Herstellens und Mischens von Indiumoxidpulver, Wolframoxidpulver und Zinkpulver, so dass das Atomverhältnis von Wolfram hinsichtlich Indium 0,001 bis 0,034 beträgt und das Atomverhältnis von Zink hinsichtlich Indium 0,00018 bis 0,017 beträgt; einen zweiten Schritt des Durchführens von kaltem isostatischen Pressen der Verbindung, die in dem ersten Schritt erhalten wurde, bei einem Druck größer als 9,8 MPa bis 294 MPa, um einen Presskörper zu bilden; und einen dritten Schritt des Durchführens von Sintern des Presskörpers, der in dem zweiten Schritt erhalten wurde, in einem Sinterofen bei Atmosphärendruck bei einer Temperatur von 1000 °C bis 1300 °C für einen Zeitraum von einer Stunde bis fünf Stunden, um einen Oxidsinterkörper für eine Verdampfungsquelientablette, der Indiumoxid enthält, zu erhalten, wobei Wolfram und Zink in fester Lösung enthalten sind, so dass das Atomverhältnis von Wolfram hinsichtlich Indium 0,001 bis 0,034 beträgt, das Atomverhältnis von Zink hinsichtlich indium 0,00018 bis 0,017 beträgt und die Dichte 4,0 g/cm³ bis 6,0 g/cm³ beträgt, der Oxidsinterkörper keine metallische Phase enthält und eine mittlere Kristallkorngröße von 10 µm oder weniger aufweist.

8. Herstellungsverfahren für einen Oxidsinterkörper gemäß Anspruch 6 oder 7, wobei der Sinterprozess in einer Atmosphäre durchgeführt wird, bei der Sauerstoff in den Sinterofen bei einem Verhältnis von 3 bis 8 L/min pro 0,1 m³ des Ofenvolumens eingeleitet wird.

9. Herstellungsverfahren für einen Oxidsinterkörper gemäß Anspruch 8, wobei, wenn der Ofen nach dem Sinterprozess abkühlt, die Einleitung von Sauerstoff angehalten wird.

10. Transparente leitfähige Oxidschicht, die durch ein Vakuumverdampfungsverfahren unter Verwendung einer Tablette hergestellt wird, die erhalten wird durch Verarbeiten des Oxidsinterkörpers für eine Verdampfungsquellentablette gemäß einem der Ansprüche 1 bis 3, wobei der Film kristallin ist und einen spezifischen Widerstand von 9 x 10⁻⁴ Ωcm oder weniger aufweist, die mittlere Transmission der Schicht selbst 82 % oder mehr bei Licht mit einer Wellenlänge von 400 bis 800 nm und 80 % oder mehr bei Licht mit einer Wellenlänge von 900 bis 1100 nm beträgt.

11. Verfahren zur Herstellung einer transparenten leitfähigen Oxidschicht, bei welchem eine Tablette, die durch Verarbeiten des Oxidsinterkörpers für eine Verdampfungsquellentablette gemäß einem der Ansprüche 1 bis 3 erhalten wurde, verwendet wird, und wobei, nachdem eine Schicht durch Vakuumverdampfung auf einem Glassubstrat bei einer Temperatur von 130°C oder weniger hergestellt wurde, die hergestellte Schicht in Inertgas oder in einem Vakuum bei 200 bis 400 °C wärmebehandelt wird.

## Revendications

1. Bloc d'oxyde fritté pour plaquette de source de vaporisation contenant de l'oxyde d'indium, dans lequel du tungstène est contenu en solution solide de telle sorte que le rapport atomique du tungstène par rapport à l'indium soit de 0,001 à 0,034, et la densité soit de 4,0 g/cm³ à 5,9 g/cm³, le bloc d'oxyde fritté ne contenant aucune phase métallique et présentant une taille moyenne de grain cristallin inférieure ou égale à 10 µm.

2. Bloc d'oxyde fritté pour plaquette de source de vaporisation contenant de l'oxyde d'indium, dans lequel du tungstène et du zinc sont contenus en solution solide de telle sorte que le rapport atomique du tungstène par rapport à l'indium soit de 0,001 à 0,034, le rapport atomique du zinc par rapport à l'indium soit de 0,00018 à 0,017, et la densité soit de 4,0 g/cm³ à 6,0 g/cm³, le bloc d'oxyde fritté ne contenant aucune phase métallique et présentant une taille moyenne de grain cristallin inférieure ou égale à 10 µm.

3. Bloc d'oxyde fritté pour plaquette de source de vaporisation selon la revendication 1 ou 2, dans lequel la résistivité spécifique est inférieure ou égale à 1 k cm.

4. Procédé de fabrication d'un bloc d'oxyde fritté comprenant : une première étape de préparation et de mélange de poudre d'oxyde d'indium et de poudre d'oxyde de tungstène de telle sorte que le rapport atomique du tungstène par rapport à l'indium soit de 0,001 à 0,034 ; et une deuxième étape de mise en oeuvre d'un frittage sous pression à chaud du composé obtenu dans la première étape à une température de 700°C à 900°C, pendant une période supérieure ou égale à 1 heure et inférieure à 3 heures, et sous une pression de 2,45 MPa à 29,40 MPa de manière à obtenir un bloc d'oxyde fritté pour plaquette de source de vaporisation contenant de l'oxyde d'indium, dans lequel le tungstène est contenu en solution solide de telle sorte que le rapport atomique du tungstène par rapport à l'indium soit de 0,001 à 0,034, et la densité soit de 4,0 g/cm³ à 5,9 g/cm³, le bloc d'oxyde fritté ne contenant aucune phase métallique et présentant une taille moyenne de grain cristallin inférieure ou égale à 10 µm.

5. Procédé de fabrication d'un bloc d'oxyde fritté comprenant : une première étape de préparation et de mélange de poudre d'oxyde d'indium, de poudre d'oxyde de tungstène et de poudre d'oxyde de zinc de telle sorte que le rapport atomique du tungstène par rapport à l'indium soit de 0,001 à 0,034 ; et le rapport atomique du zinc par rapport à l'indium soit de 0,00018 à 0,017 ; et une deuxième étape de mise en oeuvre d'un frittage sous pression à chaud du composé obtenu dans la première étape à une température de 700°C à 900°C, pendant une période supérieure ou égale à 1 heure et inférieure à 3 heures, et sous une pression de 2,45 MPa à 29,40 MPa de manière à obtenir un bloc d'oxyde fritté pour plaquette de source de vaporisation contenant de l'oxyde d'indium, dans lequel le tungstène et le zinc sont contenus en solution solide de telle sorte que le rapport atomique du tungstène par rapport à l'indium soit de 0,001 à 0,034, le rapport atomique du zinc par rapport à l'indium soit de 0,00018 à 0,017, et la densité soit de 4,0 g/cm³ à 6,0 g/cm³, le bloc d'oxyde fritté ne contenant aucune phase métallique et présentant une taille moyenne de grain cristallin inférieure ou égale à 10 µm.

6. Procédé de fabrication d'un bloc d'oxyde fritté comprenant : une première étape de préparation et de mélange de poudre d'oxyde d'indium et de poudre d'oxyde de tungstène de telle sorte que le rapport atomique du tungstène par rapport à l'indium soit de 0,001 à 0,034 ; une deuxième étape de mise en oeuvre d'une pression isostatique à froid du composé obtenu dans la première étape sous une pression de 9,8 MPa à 294 MPa de manière à former un élément compact ; et une troisième étape de mise en oeuvre d'un frittage de l'élément compact obtenu dans la deuxième étape dans un four de frittage à la pression atmosphérique, sous une température supérieure ou égale à 1300°C, pendant une période supérieure ou égale à 5 heures de manière à obtenir un bloc d'oxyde fritté pour plaquette de source de vaporisation contenant de l'oxyde d'indium, dans lequel le tungstène est contenu en solution solide de telle sorte que le rapport atomique du tungstène par rapport à l'indium soit de 0,001 à 0,034, et la densité soit de 4,0 g/cm³ à 5,9 g/cm³, le bloc d'oxyde fritté ne contenant aucune phase métallique et présentant une taille moyenne de grain cristallin inférieure ou égale à 10 µm.

7. Procédé de fabrication d'un bloc d'oxyde fritté comprenant : une première étape de préparation et de mélange de poudre d'oxyde d'indium, de poudre d'oxyde de tungstène et de poudre de zinc de telle sorte que le rapport atomique du tungstène par rapport à l'indium soit de 0,001 à 0,034 et le rapport atomique du zinc par rapport à l'indium soit de 0,00018 à 0,017 ; une deuxième étape de mise en oeuvre d'une pression isostatique à froid du composé obtenu dans la première étape à une pression supérieure à 9,8 MPa et jusqu'à 294 MPa de manière à former un élément compact; et une troisième étape de mise en oeuvre du frittage de l'élément compact obtenu dans la deuxième étape dans un four de frittage sous une pression atmosphérique, à une température de 1000°C à 1300°C, pendant une période de 1 heure à 5 heures de manière à obtenir un bloc d'oxyde fritté pour plaquette de source de vaporisation contenant de l'oxyde d'indium, dans lequel du tungstène et du zinc sont contenus en solution solide de telle sorte que le rapport atomique du tungstène par rapport à l'indium soit de 0,001 à 0,034, le rapport atomique du zinc par rapport à l'indium soit de 0,00018 à 0,017, et la densité soit de 4,0 g/cm³ à 6,0 g/cm³, le bloc d'oxyde fritté ne contenant aucune phase métallique et présentant une taille moyenne de grain cristallin inférieure ou égale à 10 µm.

8. Procédé de fabrication d'un bloc d'oxyde fritté selon la revendication 6 ou 7, dans lequel le traitement de frittage est mis en oeuvre dans une atmosphère dans laquelle de l'oxygène est introduit dans le four de frittage suivant un rapport de 3 à 8 1/mn pour 0,1 m³ de volume du four.

9. Procédé de fabrication d'un bloc d'oxyde fritté selon la revendication 8, dans lequel, lors du refroidissant du four après le traitement de frittage, l'introduction d'oxygène est arrêtée.

10. Film d'oxyde conducteur transparent qui est fabriqué par un procédé de vaporisation sous vide en utilisant une plaquette qui est obtenue par traitement du bloc d'oxyde fritté pour plaquette de source de vaporisation selon l'une quelconque des revendications 1 à 3, le film étant cristallin et présentant une résistivité spécifique inférieure ou égale à 9 x 10⁻⁴ cm, un facteur de transmission moyen du film lui-même supérieur ou égal à 82% pour une lumière présentant une longueur d'onde de 400 à 800 nm et supérieur ou égal à 80% pour une lumière présentant une longueur d'onde de 900 à 1100 nm.

11. Procédé de fabrication d'un film d'oxyde conducteur transparent dans lequel une plaquette qui est obtenue par traitement du bloc d'oxyde fritté pour plaquette de source de vaporisation selon l'une quelconque des revendications 1 à 3 est utilisé, et dans lequel après qu'un film a été réalisé par vaporisation sous vide sur un substrat de verre à une température inférieure à 130°C ou moins, le film réalisé est soumis à un traitement thermique sous gaz inerte ou dans un vide entre 200 et 400°C.
